(19) Europäisches Patentamt
European Patent Office
Office européen des brevets

(11) **EP 3 388 546 A1**

(12) **EUROPEAN PATENT APPLICATION**
published in accordance with Art. 153(4) EPC

(43) Date of publication:
**17.10.2018 Bulletin 2018/42**

(21) Application number: **16870380.9**

(22) Date of filing: **04.11.2016**

(51) Int Cl.:
***C23C 14/06*** *(2006.01)* ***B23B 27/14*** *(2006.01)*
***C23C 14/02*** *(2006.01)* ***C23C 14/32*** *(2006.01)*
***C22C 29/08*** *(2006.01)*

(86) International application number:
**PCT/JP2016/082794**

(87) International publication number:
**WO 2017/094440 (08.06.2017 Gazette 2017/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **02.12.2015 JP 2015235672**

(71) Applicant: **Mitsubishi Hitachi Tool Engineering, Ltd.**
**Tokyo 130-0026 (JP)**

(72) Inventors:
- **FUWA Ryoutarou**
**Narita-shi**
**Chiba 286-0825 (JP)**
- **KUBOTA Kazuyuki**
**Yasu-shi**
**Shiga 520-2323 (JP)**
- **FUKUNAGA Yuuzoh**
**Narita-shi**
**Chiba 286-0825 (JP)**

(74) Representative: **Hoffmann Eitle**
**Patent- und Rechtsanwälte PartmbB**
**Arabellastraße 30**
**81925 München (DE)**

(54) **HARD COATING, HARD COATING-COVERED MEMBER AND MANUFACTURING METHOD THEREFOR, AND TARGET USED FOR PRODUCING HARD COATING AND MANUFACTURING METHOD THEREFOR**

(57) A hard coating having a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively, having M-O bonds without Al-O bonds exceeding an inevitable impurity level as a bonding state identified by X-ray photoelectron spectroscopy, and having only an NaCl-type structure in its X-ray diffraction pattern.

Fig. 5

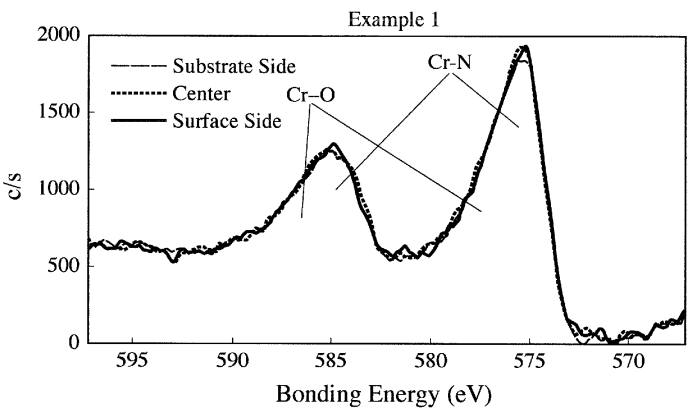


EP 3 388 546 A1

## Description

FIELD OF THE INVENTION

The present invention relates to a hard (AlTiM)NO coating having excellent oxidation resistance and wear resistance, a hard-(AlTiM)NO-coated member and its production method, and a target used for producing a hard (AlTiM)NO coating and its production method.

BACKGROUND OF THE INVENTION

To provide long lives to tools for cutting works at a high feed or speed, dies used under severe molding conditions, etc., various hard coatings having excellent oxidation resistance and wear resistance have been proposed. For example, JP 3877124 B discloses a hard AlTiCrNO coating comprising at least Al, Ti, Cr, N and O, the non-metal component being $N_wO_{100-w}$, wherein w is 70-99 atomic %, and having a multi-layer structure comprising a layer A having an oxygen content of 1-10 atomic %, and a layer B having an oxygen content of more than 10 atomic % and 30 atomic % or less. JP 3877124 B describes that the oxygen content in the AlTiCrNO coating is controlled by using a mixed gas of nitrogen and oxygen, with their mixing ratio adjusted. However, because the method of JP 3877124 B uses an oxygen-containing atmosphere, oxygen in the atmosphere is predominantly reacted with Al, resulting in a hard AlTiCrNO coating having Al-O bonds exceeding an inevitable impurity level. Accordingly, the hard AlTiCrNO coating of JP 3877124 B does not have sufficient oxidation resistance and wear resistance to meet recent demand of high performance for cutting tools, etc.

JP 4846519 B discloses a target comprising Al, a component M (one or more elements selected from metals of Groups 4a, 5a and 6a, Si, B and S), and Al nitride, the amount of Al nitride contained being 5-30% by mol. JP 5487182 B discloses a target for sputtering, which is made of a Ti-Al alloy containing 1-30 atomic % of Al, Al forming a solid solution with Ti or an intermetallic compound with Ti, and an average oxygen content in the Ti-Al alloy being 1070 ppmw or less. However, because the targets described in JP 4846519 B and JP 5487182 B do not contain oxygen in an amount exceeding an inevitable impurity level, oxygen is introduced into the coating from the atmosphere. Accordingly, oxygen-containing hard coatings obtained by using the targets of JP 4846519 B and JP 5487182 B have Al-O bonds exceeding an inevitable impurity level, failing to exhibit sufficient oxidation resistance and wear resistance, like the hard coating of JP 3877124 B.

JP 2009-220260 A discloses a coated tool having a W-modified phase having a bcc structure, a carbide phase and a hard nitride coating formed in this order on a WC-based cemented carbide substrate. The W-modified phase is formed by ion bombardment in an apparatus comprising an arc discharge evaporation source. In the ion bombardment, negative bias voltage P1 of -1000 V to -600 V is applied to a substrate at a surface temperature of 800-860°C, and the substrate is irradiated with metal ions (Ti ions) evaporated from the arc discharge evaporation source in a hydrogen-containing Ar gas of 0.01-2 Pa. However, because the targets [C1 (for example, $Ti_{100}$), C2 (for example, $Al_{70}Cr_{30}$) and C3 (for example, $Ti_{75}Si_{25}$)] used do not contain oxygen in an amount exceeding an inevitable impurity level, the resultant hard nitride coatings do not contain oxygen in an amount exceeding an inevitable impurity level, failing to sufficiently exhibit targeted oxidation resistance and wear resistance.

JP 2008-533310 A discloses a method for forming a hard coating of $(Al_xCr_{1-x})_yO_z$ in an oxygen-containing atmosphere, using an arc vapor deposition apparatus comprising a target electrode connected to a pulse power source. In the method of JP 2008-533310 A, however, oxygen is introduced from an atmosphere gas using a target containing no oxygen, so that the resultant hard coating has Al-O bonds exceeding an inevitable impurity level, failing to exhibit sufficient oxidation resistance and wear resistance.

OBJECTS OF THE INVENTION

Accordingly, the first object of the present invention is to provide a long-life (AlTiM)NO coating having excellent oxidation resistance and wear resistance.

The second object of the present invention is to provide a hard-coated member (cutting tool, die, etc.) having a long-life (AlTiM)NO coating having excellent oxidation resistance and wear resistance.

The third object of the present invention is to provide a method for producing such a hard-coated member.

The fourth object of the present invention is to provide a target used for forming such (AlTiM)NO coating, and its production method.

DISCLOSURE OF THE INVENTION

The hard coating of the present invention has a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq$

0.38, $0.02 \leq z \leq 0.2$, $x + y + z = 1$, $0.2 \leq a \leq 0.8$, and $0.02 \leq b \leq 0.10$, respectively;
the hard coating having M-O bonds without Al-O bonds exceeding an inevitable impurity level as a bonding state identified by X-ray photoelectron spectroscopy, and having only an NaCl-type structure in its X-ray diffraction pattern.

Practically, the hard coating preferably has an NaCl-type structure as a main structure and a wurtzite-type structure as a sub-structure in its electron diffraction pattern.

The hard-coated member of the present invention comprises the above hard coating formed on a substrate. The hard-coated member preferably has an intermediate layer formed by a vapor deposition method between the substrateと the hard coating との間に; the intermediate layer comprising an element in the 4a, 5a and 6a groups, at least one metal element selected from Al and Si, and at least one element selected from B, O, C and N.

The hard-coated member is provided with improved oxidation resistance and wear resistance by successively forming on the hard coating an oxynitride layer having a composition represented by $(Al_hCr_i)_c(N_jO_k)_d$, wherein h, i, j, k, c and d are numbers meeting by atomic ratio h = 0.1-0.6, h + i = 1, j = 0.1-0.8, j + k = 1, c = 0.35-0.6, and c + d = 1, respectively, and an oxide layer having a composition represented by $(Al_mCr_n)_2O_3$, wherein m and n are numbers meeting by atomic ratio m = 0.1-0.6, and m + n = 1, respectively, by a vapor deposition method.

The method of the present invention for producing a hard-coated member having the above hard coating on a substrate by arc ion plating, comprising
using a target having a composition represented by $(Al)_p(AlN)_q(Ti)_r(TiN)_s(MN)_t(MO_x)_u$, wherein M is at least one element of Cr and Nb, p, q, r, s, t and u are numbers meeting by atomic ratio $0.59 \leq p \leq 0.8$, $0.01 \leq q \leq 0.1$, $0.04 \leq r \leq 0.35$, $0.03 \leq s \leq 0.15$, $0.01 \leq t \leq 0.20$, $0.01 \leq u \leq 0.1$, and $p + q + r + s + t + u = 1$, respectively, and x is a number of 1-2.5 by atomic ratio, in a nitriding gas atmosphere.

It is preferable that in the above method,
the substrate is kept at a temperature of 400-550°C in a nitriding gas atmosphere;
DC bias voltage or unipolar pulse bias voltage of -270 V to -20 V is applied to the substrate;
pulse arc current is supplied to the target set on an arc discharge evaporation source; and
the pulse arc current has a substantially rectangular waveform having the maximum arc current of 90-120 A and the minimum arc current of 50-90 A, difference between the maximum arc current and the minimum arc current being 10 A or more, a frequency of 2-15 kHz, and a duty ratio of 40-70%.

When the substrate is made of WC-based cemented carbide, a thin modifying layer having an fcc structure is preferably formed on the substrate surface before forming the hard coating. A first modifying layer is formed in an argon gas atmosphere having a flow rate of 30-150 sccm by applying negative DC voltage of -850 V to -500 V to the substrate kept at a temperature of 400-700°C, and supplying arc current of 50-100 A to a target set on the arc discharge evaporation source, the target having a composition of $Ti_eO_{1-e}$, wherein e is a number representing the atomic ratio of Ti, which meets $0.7 \leq e \leq 0.95$, thereby subjecting a surface of the substrate to bombardment with ions generated from the target. A second modifying layer is formed in an argon gas atmosphere having a flow rate of 30-150 sccm by applying negative DC voltage of -1000 V to -600 V to the substrate kept at a temperature of 450-750°C, and supplying arc current of 50-100 A to a target set on the arc discharge evaporation source, the target having a composition of $Ti_fB_{1-f}$, wherein f is a number representing the atomic ratio of Ti, which meets $0.5 \leq f \leq 0.9$, thereby subjecting a surface of the substrate to bombardment with ions generated from the target. In any case, the (AlTiM)NO coating having the same crystal structure is formed immediately on the modifying layer, so that remarkably increased adhesion is obtained than when the (AlTiM)NO coating is formed directly on the WC-based cemented carbide without the modifying layer.

The method of the present invention for producing a target is changed by hot-pressing a mixture powder comprising AlTi alloy powder, AlN powder, TiN powder, MN powder, and $MO_x$ powder, wherein M is at least one element of Cr and Nb, in vacuum to form a sintered body. In the first embodiment, the MN powder is CrN powder, and the $MO_x$ powder is at least one of $Cr_2O_3$ powder, CrO powder and $CrO_2$ powder. In the second embodiment, the MN powder is NbN powder, and the $MO_x$ powder is at least one of $Nb_2O_5$ powder, NbO powder, $Nb_2O_3$ powder and $NbO_2$ powder.

EFFECTS OF THE INVENTION

Because the hard coating of the present invention is constituted by polycrystalline grains of Al-rich (AlTiM)NO having M-O bonds (M is Cr and/or Nb) with substantially no Al-O bonds when observed by X-ray photoelectron spectroscopy, it has remarkably improved oxidation resistance and wear resistance than conventional (AlTi)NO coatings in which O is mainly bonded to Al. Accordingly, a member (cutting tool, die, etc.) having the hard coating of the present invention has a remarkably longer life than conventional ones.

Because the method of the present invention for producing the above hard coating uses a target containing O in the form of $MO_x$ in an atmosphere containing no oxygen gas, to introduce M-O bonds into the hard coating substantially free from Al-O bonds, the structure of the hard coating can be stably and efficiently controlled.

Because the hard-coated member having the (AlTiM)NO coating of the present invention formed on a substrate of cemented carbide, ceramics, high-speed steel or tool steel has remarkably improved oxidation resistance and wear resistance than those of conventional AlTiNO-coated members, it is useful as cutting tools such as inserts, endmills, drills, etc., and various dies.

BRIEF DESCRIPTION OF THE DRAWINGS

Fig. 1 is a front view showing an example of arc ion plating apparatuses usable for forming the hard coating of the present invention.
Fig. 2 is a graph showing an example of waveforms of pulse arc current applied to an arc discharge evaporation source during forming the hard coating of the present invention.
Fig. 3 is a scanning electron (SEM) photomicrograph (magnification: 25,000 times) showing a cross section of the hard-coated tool of Example 1.
Fig. 4 is a graph showing X-ray photoelectron spectra showing the bonding states of Ti in three portions of a cross section of the (AlTiCr)NO coating of Example 1.
Fig. 5 is a graph showing X-ray photoelectron spectra showing the bonding states of Cr in three portions of a cross section of the (AlTiCr)NO coating of Example 1.
Fig. 6 is a graph showing X-ray photoelectron spectra showing the bonding states of Al in three portions of a cross section of the (AlTiCr)NO coating of Example 1.
Fig. 7 is a graph showing an X-ray diffraction pattern of the (AlTiCr)NO coating of Example 1.
Fig. 8 is a transmission electron photomicrograph (magnification: 4,500,000 times) showing a portion A of the cross section of Fig. 3.
Fig. 9 is a schematic view showing a method for determining the average thickness of the modifying layer 33 of Fig. 8.
Fig. 10 is a photograph showing a crystal structure analyzed from a nanobeam diffraction image of the modifying layer of Example 1.
Fig. 11 is a photograph showing a crystal structure analyzed from a nanobeam diffraction image of the (AlTiCr)NO coating of Example 1.
Fig. 12 is a graph showing an energy-dispersive X-ray spectrum of a cross section of the modifying layer of Example 1.
Fig. 13 is a perspective view showing an example of insert substrates constituting the hard-coated member of the present invention.
Fig. 14 is a schematic view showing an example of indexable rotary cutting tools, to which inserts are attached.

DESCRIPTION OF THE PREFERRED EMBODIMENTS

The embodiments of the present invention will be explained in detail below, without intention of restricting the present invention thereto. Proper modifications and improvements within the scope of the technical idea of the present invention may be added based on common knowledge of those skilled in the art. Explanations of each embodiment are applicable to other embodiments unless otherwise mentioned.

[1] Hard-coated member

The hard-coated member of the present invention comprises a hard coating formed by an arc ion plating (AI) method on a substrate; the hard coating having a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively. An X-ray photoelectron spectrum indicates that the above hard coating has M-O bonds, wherein M is at least one element of Cr and Nb, without Al-O bonds exceeding an inevitable impurity level, having only an NaCl-type structure.

(A) Substrate

The substrate should be a material having high heat resistance, to which physical vapor deposition can be applied, for example, cemented carbide, cermets, high-speed steel, tool steel, ceramics such as cubic-boron-nitride-based sintered boron nitride (cBN), etc. From the aspect of strength, hardness, wear resistance, toughness and thermal stability, WC-based cemented carbide or ceramics are preferable. For example, WC-based cemented carbide comprises tungsten carbide (WC) particles and a binding phase of Co or a Co-based alloy, the amount of the binding phase being preferably 1-13.5% by mass, more preferably 3-13% by mass. Less than 1% by mass of the binding phase provides the substrate with insufficient toughness, while more than 13.5% by mass of the binding phase provides the substrate with insufficient hardness (wear resistance). The (AlTiM)NO coating of the present invention can be formed on any of as-sintered surfaces, ground surfaces and cutting edge surfaces of sintered WC-based cemented carbide.

(B) Modifying layer

When the substrate is formed by WC-based cemented carbide, the substrate surface is preferably irradiated with ions generated from a target of TiO or TiB to form a modifying layer having an fcc structure and an average thickness of 1-10 nm. Though WC, a main component of the WC-based cemented carbide, has an hcp structure, the (AlTiM)NO coating has an fcc structure. The formation of a modifying layer having an fcc structure makes 30% or more, preferably 50% or more, more preferably 70% or more of crystal lattice fringes continuous, in its boundary (interface) with the (AlTiM)NO coating, thereby providing the strong adhesion of the (AlTiM)NO coating to the WC-based cemented carbide substrate via the modifying layer.

The modifying layer formed by ion bombardment with a TiO target is a high-density, thin layer mainly comprising $W_3O$ having an fcc structure, which is formed by introducing a trace amount of O into WC particles constituting the WC-based cemented carbide substrate, and/or CoO having an fcc structure, which is formed by introducing a trace amount of O into Co. With this structure, the modifying layer unlikely provides starting points of fracture. A modifying layer formed by ion bombardment with a TiB target is also a high-density, thin layer having an fcc structure, unlikely providing starting points of fracture. The modifying layer having an average thickness of less than 1 nm fails to provide sufficient adhesion of the hard coating to the substrate, while the modifying layer having an average thickness of more than 10 nm provides rather low adhesion.

(C) (AlTiM)NO coating

(1) Composition

The (AlTiM)NO coating of the present invention formed by an arc ion plating (AI) method is made of oxynitride comprising Al, Ti and M (Cr and/or Nb) as indispensable elements. The (AlTiM)NO coating has a composition represented by the general formula of $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively. The (AlTiM)NO coating of the present invention is characterized by having M-O bonds identified by X-ray photoelectron spectroscopy, without Al-O bonds exceeding an inevitable impurity level, and having only an NaCl-type structure in its X-ray diffraction pattern. "Without Al-O bonds exceeding an inevitable impurity level" means that the X-ray photoelectron spectrum of the (AlTiM)NO coating does not have a peak of Al-O bonds exceeding an inevitable impurity level.

With the total amount (x + y + z) of Al, Ti and M being 1, when the percentage x of Al is less than 0.6, the hard coating has insufficient oxidation resistance and wear resistance, and when the percentage x of Al is more than 0.8, the hard coating has an hcp structure as a main structure, resulting in deteriorated wear resistance. The preferred percentage x range of Al is 0.6-0.75.

With the total amount (x + y + z) of Al, Ti and M being 1, when the amount y of Ti is less than 0.05, extremely deteriorated adhesion is provided between the (AlTiM)NO coating and the substrate. On the other hand, when the amount y is more than 0.38, the amount of Al in the hard coating is low, resulting in deteriorated oxidation resistance and wear resistance. The preferred amount y of Ti is in a range of 0.1-0.3.

With the total amount (x + y + z) of Al, Ti and M being 1, when the amount z of M is less than 0.02, substantially no M-O bonds are observed in the X-ray photoelectron spectrum, providing the hard coating with deteriorated oxidation resistance and wear resistance. On the other hand, when the amount z exceeds 0.2, the (AlTiM)NO coating is turned amorphous, resulting in low wear resistance. The preferred amount z of M is in a range of 0.05-0.15.

With the total amount of metal components (AlTiM) and non-metal components (nitrogen and oxygen) in the (AlTiM)NO coating being 1, when the amount a of metal components (AlTiM) is less than 0.2, impurities are likely introduced into crystal grain boundaries of polycrystalline (AlTiM)NO. The impurities are introduced from residues removing in the film-forming apparatus. In such case, the (AlTiM)NO coating having low adhesion intensity is easily broken by external shock. On the other hand, when the amount a of metal components (AlTiM) exceed 0.8, the metal components (AlTiM) become excessive, resulting in large crystal strain and low adhesion to the substrate, so that the (AlTiM)NO coating is easily peelable. The preferred amount a of metal components (AlTiM) is in a range of 0.25-0.75.

When the amount b of oxygen in the (AlTiM)NO coating is less than 0.02 or more than 0.10, the (AlTiM)NO coating has low oxidation resistance and wear resistance. The preferred amount b of oxygen is in a range of 0.03-0.10.

The (AlTiM)NO coating of the present invention may contain C and/or B. In this case, the total amount of C and B is preferably 30 atomic % or less of the NO content, more preferably 10 atomic % or less to keep high wear resistance. When C and/or B are contained, the (AlTiM)NO coating may be called oxynitrocarbide, oxynitroboride or oxynitrocarboboride.

Taking an (AlTi)N-coated cutting tool for example, a mechanism by which the (AlTiM)NO coating of the present invention has higher oxidation resistance and wear resistance than those of conventional coatings is considered as follows: In a conventional (AlTi)N-coated cutting tool, a large amount of oxygen is introduced into the coating during a cutting operation, Al on the coating surface is predominantly oxidized, forming an Al oxide layer. In this case, Ti is simultaneously oxidized, forming a brittle Ti oxide layer having an extremely low density under the Al oxide layer. This is due to the fact that the free energy of forming Al oxide is smaller than that of Ti oxide. The brittle Ti oxide layer provides starting points of coating fracture during a cutting operation, so that it is easily broken and detached together with the Al oxide layer. Thus, the formation of the Al oxide layer and the detachment of the coating starting from the Ti oxide layer are repeated, damaging the coating. This trouble also occurs in the (AlTiM)NO coating containing oxygen introduced from the atmosphere.

On the other hand, the (AlTiM)NO coating of the present invention has M-O (Cr-O and/or Nb-O) bonds, making the coating extremely dense, thereby suppressing the diffusion of oxygen. Accordingly, oxygen for oxidizing Ti is hardly diffused into the coating even when heat is generated during a cutting operation. Also, oxygen existing in the form of M-O bonds in the (AlTiM)NO coating is bonded to Al by heat generated during a cutting operation, but not bonded to Ti having a larger free energy of forming oxide than that of Al. As a result, a brittle Ti oxide layer is not formed even though an Al oxide layer is formed, so that the (AlTiM)NO coating of the present invention keeps excellent oxidation resistance and wear resistance. Thus, to exhibit excellent oxidation resistance and wear resistance, simply containing O may not necessarily be good for the (AlTiM)NO coating, but O should be bonded to M, without substantially bonding to Al.

(2) Average thickness

The average thickness of the (AlTiM)NO coating of the present invention is preferably 0.5-15 μm, more preferably 1-12 μm. With the thickness within this range, the (AlTiM)NO coating is not peeled from the substrate, exhibiting excellent oxidation resistance and wear resistance. With the average thickness of less than 0.5 μm, the (AlTiM)NO coating is not sufficiently effective. On the other hand, the average thickness exceeding 15 μm provides an excessive residual stress, making the (AlTiM)NO coating easily peelable from the substrate. It should be noted that the thickness of a not-flat (AlTiM)NO coating is expressed by "average thickness," and that when the term "thickness" is simply used, it means "average thickness."

(3) Crystal structure

The (AlTiM)NO coating of the present invention has only an NaCl-type structure in its X-ray diffraction pattern. Also, the (AlTiM)NO coating of the present invention may have an NaCl-type structure as a main structure and other structures (wurtzite-type structure, etc.) as sub-structures, in its selected-field diffraction pattern (electron diffraction pattern) of TEM. A practical (AlTiM)NO coating preferably has an NaCl-type structure as a main structure and a wurtzite-type structure as a sub-structure.

(D) Multi-layer hard coating

The (AlTiM)NO coating of the present invention need not be a single layer but may have a multi-layer structure of two or more (AlTiM)NO coatings having different compositions, as long as it has a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively. Such multi-layer structure provides the (AlTiM)NO coating with increased wear resistance and oxidation resistance.

(E) Intermediate layer

An intermediate layer indispensably comprising at least one element selected from the group consisting of elements in the 4a, 5a and 6a groups, Al and Si, and at least one element selected from the group consisting of B, O, C and N may be formed by vapor deposition between the substrate and the (AlTiM)NO coating. The composition of the intermediate layer may be at least one of TiN, and (TiAl)N, (TiAl)NC, (TiAl)NCO, (TiAlCr)N, (TiAlCr)NC, (TiAlCr)NCO, (TiAlNb)N, (TiAlNb)NC, (TiAlNb)NCO, (TiAlW)N and (TiAlW)NC, (TiSi)N, (TiB)N, TiCN, $Al_2O_3$, $Cr_2O_3$, $(AlCr)_2O_3$, (AlCr)N, (AlCr)NC and (AlCr)NCO each having an NaCl-type structure as a main structure. The intermediate layer may be a single layer or a multi-layer.

[2] Forming apparatus

An AI apparatus is used to form the (AlTiM)NO coating, and an AI apparatus or other vapor deposition apparatuses (sputtering apparatus, etc.) are used to form the modified layer and the intermediate layer. As shown in Fig. 1, for example, the AI apparatus comprises, for example, arc discharge evaporation sources 13, 27 each attached to a vacuum chamber 5 via an insulator 14; targets 10, 18 each mounted to each arc discharge evaporation source 13, 27; arc discharge power sources 11, 12 each connected to each arc discharge evaporation source 13, 27; a column 6 rotatably supported by the vacuum chamber 5 via a bearing 4; a holder 8 supported by the column 6 for holding substrate 7; a driving means 1 for rotating the column 6; and a bias power source 3 applying bias voltage to the substrate 7. The vacuum chamber 5 has a gas inlet 2 and a gas outlet 17. Arc ignition mechanisms 16, 16 are mounted to the vacuum chamber 5 via arc ignition mechanism bearings 15, 15. Electrodes 20 are mounted to the vacuum chamber 5 via insulators 19, 19. A shield plate 23 is mounted to the vacuum chamber 5 via shield plate bearings 21 between the target 10 and the substrate 7. Though not depicted in Fig. 1, the shield plate 23 is vertically or laterally taken out of the vacuum chamber 5, for example, by a shield plate driving means 22, to carry out the formation of the (AlTiM)NO coating of the present invention.

(A) Target for forming (AlTiM)NO coating

(1) Composition

The target for forming the (AlTiM)NO coating of the present invention has a composition represented by $(Al)_p(AlN)_q(Ti)_r(TiN)_s(MN)_t(MO_x)_u$, wherein M is at least one element of Cr and Nb; p, q, r, s, t and u are numbers meeting by atomic ratio $0.59 \leq p \leq 0.8$, $0.01 \leq q \leq 0.1$,$0.04 \leq r \leq 0.35$, $0.03 \leq s \leq 0.15$, $0.01 \leq t \leq 0.20$, $0.01 \leq u \leq 0.1$, and $p + q + r + s + t + u = 1$, respectively; and x is a number ranging from 1 to 2.5 by atomic ratio, except for inevitable impurities. (AlN), (TiN) and (MN) are $(Al_1N_1)$, $(Ti_1N_1)$ and $(M_1N_1)$, respectively, by atomic ratio. $(MO_x)$ is $(M_1O_x)$ by atomic ratio. When the element M is Cr, $MO_x$ is at least one of $Cr_2O_3$, CrO and $CrO_2$, mainly $Cr_2O_3$. When the element M is Nb, $MO_x$ is at least one of $Nb_2O_5$, NbO, $Nb_2O_3$ and $NbO_2$, mainly $Nb_2O_5$. With p, q, r, s, t and u outside the above ranges, the (AlTiM)NO coating of the present invention cannot be formed. p, q, r, s, t and u are preferably numbers meeting by atomic ratio $0.59 \leq p \leq 0.75$, $0.01 \leq q \leq 0.10$, $0.05 \leq r \leq 0.25$, $0.05 \leq s \leq 0.15$, $0.01 \leq t \leq 0.15$, $0.02 \leq u \leq 0.10$, and $p + q + r + s + t + u = 1$, respectively.

The above target contains, in addition to metal Al and metal Ti, (a) Al nitride, Ti nitride and M nitride, thereby drastically reducing the amount of droplets generated during arc discharge, and suppressing the amount of oxygen discharged from the target; and (b) M oxide, thereby introducing M-O bonds into the (AlTiM)NO coating.

The suppression of droplets appears to be due to the fact that nitrogen in Al nitride, Ti nitride and M nitride is ionized near the target surface during arc discharge, thereby increasing an arc-spot-moving speed. With Al nitride, Ti nitride and M nitride each having a high melting point existing very near an Al phase on the evaporating surface, the area of a low-melting-point Al phase decreases, avoiding the concentration of arc discharge. As a result, the amount of droplets is reduced, and the generation of large droplets is suppressed. Because the growth of polycrystalline grains is not hindered in an (AlTiM)NO coating with reduced droplets, a high-density, high-strength (AlTiM)NO coating is obtained.

A main reason why the oxygen content can be reduced when forming the above target and (AlTiM)NO coating is that with part of Al and Ti in the target existing in the form of a chemically stable nitride, the oxidation of the starting material powder for the target is suppressed in the mixing and hot-pressing steps, etc. of the starting material powder. With oxidation suppressed, the oxygen content of the target is drastically lowered, resulting in a drastically reduced amount of oxygen emitted from the target during arc discharge. As a result, the unintended inclusion of oxygen in the (AlTiM)NO coating is suppressed, resulting in remarkably decreased oxidation of Ti. Because suppressed oxidation reduces the amount of droplets in the (AlTiM)NO coating, the growth of polycrystalline grains is not hindered. Further, with reduced segregation of crystal grain boundaries, it has a sound structure having well-grown polycrystalline grains.

$MO_x$ in the above target is necessary for adding M-O bonds to the coating. $MO_x$ is turned to M ions and O ions by arc spot, forming M-O bonds in the (AlTiM)NO coating. With a small amount of insulating $MO_x$ added, the target keeps sufficient conductivity, so that arc discharge by the AI method is not hindered.

(2) Production method

The target for the (AlTiM)NO coating can be formed by a powder metallurgy method. First, AlTi alloy powder, AlN powder, TiN powder, MN powder and $MO_x$ powder are mixed for several hours (for example, 5 hours) in an argon gas atmosphere in a ball mill. To obtain a sintered body having a high density, the average diameter of each powder is preferably 0.01-500 μm, more preferably 0.1-100 μm. The average diameter of each powder is determined by observation with SEM. To avoid uneven composition distribution and the inclusion of impurities, alumina balls having purity of 99.999% or more are preferably used for media. The mixed powder is sintered in a graphite die in a vacuum hot-pressing apparatus. To prevent a trace amount of oxygen contained in a sintering atmosphere from entering the target, pressing and sintering are carried out preferably after reaching a vacuum degree of 1 x $10^{-3}$ Pa to 10 x $10^{-3}$ Pa (for example, 7 x $10^{-3}$ Pa) in the hot-pressing apparatus. A pressing load is preferably 100-200 MPa (for example, 170 MPa). To avoid Al from melting during sintering, sintering is conducted preferably at a temperature of 520-580°C (for example, 550°C) for several hours (for example, 2 hours). The resultant target is machined to a shape suitable for the AI apparatus.

(B) Target for forming modifying layer

(1) TiO target

The TiO target forming a modified layer preferably has a composition represented by $Ti_eO_{1-e}$, wherein e is a number representing the atomic ratio of Ti, which meets $0.7 \leq e \leq 0.95$, except for inevitable impurities. When the atomic ratio e of Ti is less than 0.7, oxygen is excessive, failing to obtain a modified layer having an fcc structure. On the other hand, when the atomic ratio e of Ti is more than 0.95, oxygen is insufficient, also failing to obtain a modified layer having an fcc structure. The atomic ratio e of Ti is preferably in a range of 0.8-0.9.

The TiO target is produced preferably by a hot-pressing method. To introduce oxygen into the target in the production process, for example, metal Ti powder is charged into a die of WC-based cemented carbide in the hot-pressing apparatus, and the die is evacuated to vacuum, to carry out sintering in an argon gas atmosphere containing 1-20% by volume (for example, 5% by volume) of an oxygen gas for several hours (for example, 2 hours). The resultant sintered body is machined to a shape suitable for the AI apparatus.

(2) TiB target

The TiB target for forming the modifying layer preferably has a composition represented by $Ti_fB_{1-f}$, wherein f is a number expressing the atomic ratio of Ti, meeting $0.5 \leq f \leq 0.9$, except for inevitable impurities. When the atomic ratio f of Ti is less than 0.5, a modifying layer having an fcc structure cannot be obtained. On the other hand, when the atomic ratio f of Ti is more than 0.9, decarburized phase is formed, failing to obtain a modified layer having an fcc structure. The atomic ratio f of Ti is preferably in a range of 0.7-0.9.

The TiB target is also preferably produced by a hot-pressing method. To avoid the intrusion of oxygen as much as possible in the production step, for example, TiB powder is charged into a die of WC-based cemented carbide in the hot-pressing apparatus, to carry out sintering in an evacuated atmosphere of 1 x $10^{-3}$ Pa to 10 x $10^{-3}$ Pa (for example, 7 x $10^{-3}$ Pa) for several hours (for example, 2 hours). The resultant sintered body is machined to a shape suitable for the AI apparatus.

(C) Arc discharge evaporation source and arc discharge power source

As shown in Fig. 1, with the TiO or TiB target 10 for forming the modifying layer, and the target 18 for forming the (AlTiM)NO coating set on the arc discharge evaporation sources 13, 27, DC arc current is supplied to the target 10, and pulse arc current is supplied to the target 18, from the arc discharge power source 11, 12. Though not depicted, each arc discharge evaporation source 13, 27 is provided with a magnetic-field-generating means comprising an electromagnet and/or a permanent magnet and a yoke, to generate a magnetic field distribution having a gap magnetic flux density of several tens of G (for example, 10-50 G) near the substrate 7 on which the (AlTiM)NO coating is formed.

Even in the target of the present invention with a small percentage of low-melting-point metal Al, arc spot likely resides on Al during the formation of the (AlTiM)NO coating, resulting in a molten portion. As a result, liquid drops called "droplets" are generated, roughening (AlTiM)NO coating surface. The droplets divide the growth of polycrystalline (AlTiM)NO grains, and act as starting sites of coating breakage. As a result of intensive investigation, it has been found that pulse arc current should be supplied to the target attached to the arc discharge evaporation source to suppress the generation of droplets.

(D) Bias power source

As shown in Fig. 1, DC bias voltage or pulse bias voltage is applied to the substrate 7 from the bias power source 3.

[3] Forming conditions

The (AlTiM)NO coating of the present invention having M-O bonds without Al-O bonds exceeding an inevitable impurity level can be produced by supplying pulse arc current to the above-described target in an AI method. The production steps of the (AlTiM)NO coating of the present invention will be described below.

(A) Cleaning step of substrate

The substrate 7 set on the holder 8 in the AI apparatus shown in Fig. 1 is heated to a temperature of 250-650°C by a heater (not shown), while keeping vacuum of 1 x $10^{-2}$ Pa to 5 x $10^{-2}$ Pa (for example, 1.5 x $10^{-2}$ Pa) in the vacuum chamber 5. Though depicted in a columnar shape in Fig. 1, the substrate 7 may be in various forms such as a solid-type endmill or an insert, etc. Thereafter, an argon gas is introduced into the vacuum chamber 5 to have an argon gas atmosphere of 0.5-10 Pa (for example, 2 Pa). In this state, the substrate 7 is cleaned by argon gas bombardment, with DC bias voltage or pulse bias voltage of -250 V to -150 V applied from the bias power source 3 to the substrate 7.

The substrate temperature of lower than 250°C fails to provide the etching effect of an argon gas, while the substrate temperature of higher than 650°C saturates the etching effect of an argon gas, resulting in lower industrial productivity. The substrate temperature is measured by a thermocouple embedded in the substrate (the same is true below). With the argon gas pressure outside a range of 0.5-10 Pa in the vacuum chamber 5, the argon gas bombardment is unstable. When DC bias voltage or pulse bias voltage is less than -250 V, arcing occurs on the substrate. When it is more than -150 V, a sufficient cleaning effect by bombardment etching cannot be obtained.

(B) Step of forming modified layer

(1) TiO target

The cleaned WC-based cemented carbide substrate 7 is subjected to ion bombardment using a TiO target in an argon gas atmosphere having a flow rate of 30-150 sccm, to form a modified layer on the substrate 7. Arc current (DC current) of 50-100 A is supplied from the arc discharge power source 11 to the TiO target attached to the arc discharge evaporation source 13. With the substrate 7 heated to a temperature of 400-700°C, DC bias voltage of -850 V to -500 V is applied from the bias power source 3 to the substrate 7. By ion bombardment using the TiO target, the WC-based cemented carbide substrate 7 is irradiated with Ti ions and O ions.

When the temperature of the substrate 7 is lower than 400°C, a modified layer having an fcc structure cannot be formed. On the other hand, when the temperature of the substrate 7 is higher than 700°C, Ti oxide having a rutile structure, etc. are precipitated, deteriorating the adhesion of the hard coating. When the flow rate of an argon gas is less than 30 sccm in the vacuum chamber 5, Ti ions, etc. impinging on the substrate 7 have too much energy, forming a decarburized layer on a surface of the substrate 7, thereby deteriorating the adhesion of the hard coating. On the other hand, when the flow rate of an argon gas is more than 150 sccm, Ti ions, etc. have too low energy, failing to form the modified layer.

The arc current of less than 50 A provides unstable arc discharge, and the arc current of more than 100 A forms a lot of droplets on the substrate 7, deteriorating the adhesion of the hard coating. The DC bias voltage of less than -850 V provides Ti ions, etc. with too much energy, forming a decarburized layer on a surface of the substrate 7, and the DC bias voltage of more than -500 V fails to form a modified layer on the substrate.

(2) TiB target

Ion bombardment to the WC-based cemented carbide substrate 7 using a TiB target differs from ion bombardment using the TiO target, in that the substrate 7 is heated to a temperature of 450-750°C, and that DC bias voltage of -1000 V to -600 V is applied from the bias power source 3 to the substrate 7. By ion bombardment using the TiB target, the WC-based cemented carbide substrate is irradiated with Ti ions and B ions. With the temperature of the substrate 7 outside a range of 450-750°C, a modified layer having an fcc structure is not formed. The DC bias voltage of less than -1000 V forms a decarburized layer on a surface of the substrate 7, and the DC bias voltage of more than -600 V provides ion bombardment with substantially no effect.

(C) Step of forming (AlTiM)NO coating

To form an (AlTiM)NO coating on the substrate 7 (on the modifying layer, if any), pulse arc current is supplied to the target 18 set on the arc discharge evaporation source 27 from the arc discharge power source 12, and DC bias voltage or pulse bias voltage is applied to the substrate 7 from the bias power source 3, in a nitriding gas atmosphere.

(1) Substrate temperature

The temperature of the substrate 7 is preferably 400-550°C during forming the (AlTiM)NO coating. When the temperature of the substrate 7 is lower than 400°C, (AlTiM)NO is not fully crystallized, resulting in an (AlTiM)NO coating with insufficient wear resistance and peelable due to increased residual stress. On the other hand, when the temperature of the substrate 7 is higher than 550°C, the NaCl-type structure is unstable, resulting in an (AlTiM)NO coating with low wear resistance and oxidation resistance. The temperature of the substrate 7 is more preferably 400-540°C.

(2) Type and pressure of nitriding gas

A nitriding gas for forming the (AlTiM)NO coating on the substrate 7 may be a nitrogen gas, or a mixed gas of ammonia and hydrogen. The pressure of the nitriding gas is preferably 2-6 Pa. When the nitriding gas pressure is less than 2 Pa, nitride is not sufficiently formed. When the nitriding gas pressure is more than 6 Pa, the effect of adding a nitriding gas is saturated.

(3) Bias voltage applied to substrate

To form the (AlTiM)NO coating, DC bias voltage or unipolar pulse bias voltage of -270 V to -20 V is applied to the substrate 7. When it is less than -270 V, arcing occurs on the substrate 7, or a reverse sputtering phenomenon occurs, failing to form M-O bonds. On the other hand, when it is more than -20 V, the effect of applying bias voltage is not obtained, failing to form M-O bonds.

The more preferred DC bias voltage range is -250 V to -50 V. When unipolar pulse bias voltage is used, negative bias voltage (negative peak value except for a rapid uprising portion from zero to the negative side) is preferably -270 V to -20 V. Outside this range, the (AlTiM)NO coating of the present invention cannot be obtained. The more preferred negative bias voltage range is -250 V to -50 V. The frequency of the unipolar pulse bias voltage is preferably 20-50 kHz, more preferably 30-40 kHz.

(4) Pulse arc current

To suppress the generation of droplets and the formation of oxides on the target surface while stabilizing arc discharge during forming the (AlTiM)NO coating, pulse arc current is supplied to the target 18 for forming the (AlTiM)NO coating. As schematically shown in Fig. 2, for example, the pulse arc current has a pulse waveform having at least two substantially rectangular steps. In a period T, $t_{min}$ is a current-supplying time in a minimum ($A_{min}$)-side stable region of the pulse arc current, and $t_{max}$ is a current-supplying time in a maximum ($A_{max}$)-side stable region of the pulse arc current.

As shown in Fig. 2, in one pulse (period T) of the pulse arc current waveform, the maximum ($A_{max}$)-side stable region is between an $A_{max}$-side start point $P_1$ and an $A_{max}$-side end point $P_2$ excluding a steep rising portion (from an Amin-side end point $P_4$ to an $A_{max}$-side start point $P_1$), with the current-supplying time $t_{max}$ being from the point $P_1$ to the point $P_2$. Because the pulse current has a gradually decreasing waveform in a region from the point $P_1$ to the point $P_2$ on the $A_{max}$ side, the current of 95 A at the point $P_2$ is regarded as $A_{max}$. The minimum ($A_{min}$)-side stable region is between an Amin-side start point $P_3$ and an $A_{min}$-side end point $P_4$ excluding a steep falling portion (from the $A_{max}$-side end point $P_2$ to the Amin-side start point $P_3$), with the current-supplying time $t_{min}$ being from the point $P_3$ to the point $P_4$. Because the pulse current has a gradually decreasing waveform in a region from the point $P_3$ to the point $P_4$ on the $A_{min}$ side, the current of 65 A at the point $P_4$ is regarded as $A_{min}$.

To suppress the generation of droplets and the formation of oxides on the target surface while stabilizing arc discharge during forming the (AlTiM)NO coating, $A_{min}$ is preferably 50-90 A, more preferably 50-80 A. $A_{min}$ of less than 50 A does not cause arc discharge, failing to form the coating, and $A_{min}$ of more than 90 A increases droplets, deteriorating the oxidation resistance of the coating. $A_{max}$ is preferably 90-120 A, more preferably 90-110 A. When $A_{max}$ is outside the range of 90-120 A, droplets similarly increase, deteriorating the oxidation resistance of the coating.

The difference ΔA of $A_{max}$ and $A_{min}$ is preferably 10 A or more, more preferably 10-60 A, most preferably 20-55 A. When ΔA is less than 10 A, droplets increase, deteriorating the oxidation resistance of the coating.

The percentage of $t_{min}$ in the pulse arc current is expressed by a duty ratio D defined by the following formula:

$$D = [t_{min}/(t_{min} + t_{max})] \times 100\%,$$

wherein $t_{min}$ is a current-supplying time in a stable region of the minimum pulse arc current $A_{min}$, and $t_{max}$ is a current-supplying time in a stable region of the maximum pulse arc current $A_{max}$.

The duty ratio D is preferably 40-70%, more preferably 45-65%. When the duty ratio D is outside the range of 40-70%, arc discharge is unstable, so that the (AlTiM)NO coating has an unstable NaCl-type structure, or that droplets increase. It should be noted that the waveform of pulse arc current is not restricted to two steps shown in Fig. 2, but may have 3 or more steps (for example, 3-10 steps) as long as the waveform has at least stable regions of $A_{max}$ and $A_{min}$.

The frequency of pulse arc current is preferably 2-15 kHz, more preferably 2-14 kHz. With the frequency of pulse arc current outside the range of 2-15 kHz, arc discharge is unstable, or large amounts of oxides are formed on the target for forming the (AlTiM)NO coating.

With pulse arc current supplied under the above conditions, stable arc discharge is obtained. With the residing of arc spot on Al and the formation of oxides on the target suppressed, an AlTiMO alloy is uniformly melted and evaporated, so that the (AlTiM)NO coating having a stable composition is formed on the substrate.

Using the target containing $MO_x$ in an atmosphere gas containing no oxygen, $MO_x$ is evaporated by arc spot to form M ions and O ions, which are instantaneously reacted, resulting in an (AlTiM)NO coating having M-O bonds with substantially no Al oxide and Ti oxide. On the other hand, when arc ion plating is conducted in an oxygen-containing atmosphere, Al and Ti much more easily oxidizable than the element M are predominantly reacted with oxygen in the atmosphere, forming large amounts of Al oxide and Ti oxide in the (AlTiM)NO coating, without forming M-O bonds. An (AlTiM)NO coating containing Al oxide and Ti oxide does not have sufficient oxidation resistance and wear resistance.

The present invention will be explained in further detail by Examples below without intention of restriction. In Examples and Comparative Examples below, the target compositions are values measured by chemical analysis unless otherwise mentioned. Though inserts were used as substrates for hard coatings in Examples, the present invention is of course not restricted thereto, but other cutting tools than inserts (endmills, drills, etc.), dies, etc. may be used.

Example 1

(1) Cleaning of substrate

High-feed milling insert substrates (EDNW15T4TN-15 available from Mitsubishi Hitachi Tool Engineering, Ltd., each having a main cutting edge 35 and a flank 36 shown in Fig. 13) 30, and property-evaluating insert substrates (SNMN120408 available from Mitsubishi Hitachi Tool Engineering, Ltd.), which were made of WC-based cemented carbide having a composition comprising 6.0% by mass of Co, the balance being WC and inevitable impurities, were set on an upper holder 8 in the AI apparatus shown in Fig. 1, and heated to 600°C by a heater (not shown) simultaneously with evacuation to vacuum. Thereafter, with an argon gas in a flow rate of 500 sccm introduced into a vacuum chamber 5 to adjust the pressure to 2.0 Pa, and with DC bias voltage of -200 V applied to each substrate, each substrate was cleaned by etching with argon ion bombardment. The term "sccm" means a flow rate (cc/minute) at 1 atm and 25°C.

(2) Formation of modifying layer using TiO target

With the substrate 7 kept at 600°C, a modifying layer was formed on each substrate 7 in an argon gas flow of 50 sccm, while applying negative DC voltage of -700 V to each substrate 7 from the bias power source 3, and DC arc current of 80 A to a TiO target 10 having a composition of $Ti_{0.85}O_{0.15}$ (atomic ratio) from the arc discharge power source 11.

(3) Formation of (AlTiCr)NO coating

A target 18 having a composition of $(Al)_{0.70}(AlN)_{0.06}(Ti)_{0.09}(TiN)_{0.09}(CrN)_{0.03}(Cr_2O_3)_{0.03}$ (atomic ratio) was set at the arc discharge evaporation source 27 connected to the arc discharge power source 12. With the temperature of the substrate 7 set at 450°C, a nitrogen gas of 800 sccm was introduced into a vacuum chamber 5 to adjust the pressure to 3.1 Pa.

With DC voltage of -80 V applied to each substrate 7 from the bias power source 3, and with pulse arc current having a substantially rectangular waveform supplied to the target 18 from the arc discharge power source 12, a 3-$\mu$m-thick coating having a composition of $(Al_{0.70}Ti_{0.22}Cr_{0.08})_{0.47}N_{0.47}O_{0.06}$ (atomic ratio) was formed. The composition of the coating was measured at its thickness-direction center position by an electron probe microanalyzer EPMA (JXA-8500F available from Joel Ltd.) under the conditions of acceleration voltage of 10 kV, irradiation current of 0.05 A, and a beam diameter of 0.5 $\mu$m. Incidentally, the same measurement conditions of EPMA were used in other Examples. As shown in Fig. 2, the pulse arc current had the minimum value $A_{min}$ of 65 A, the maximum value $A_{max}$ of 95 A, a frequency of 5 kHz (period T = 2.0 x $10^{-4}$ seconds/pulse), and a duty ratio D of 50%.

Fig. 3 is a scanning electron photomicrograph (SEM photograph, magnification: 25,000 times) showing a cross-section structure of the resultant (AlTiCr)NO-coated milling insert. In Fig. 3, 31 represents the WC-based cemented carbide substrate, and 32 represents the (AlTiCr)NO coating. Because of low magnification, the modified layer is not discernible in Fig. 3.

(4) Bonding states of Ti, Cr and Al in (AlTiCr)NO coating

Using an X-ray photoelectron spectroscope (Quantum 2000 available from PHI), the (AlTiCr)NO coating was etched with argon ions to expose its surface-side portion as deep as 1/6 of the thickness of the coating from the surface, and this portion was irradiated with $AlK\alpha_1$ rays (wavelength $\lambda$: 0.833934 nm) to obtain a spectrum indicating the bonding states of Ti, Cr and Al. Further, the (AlTiCr)NO coating was etched as deep as 1/2 (center) and 5/6 (substrate side) of the thickness of the coating from the surface, to obtain spectra indicating the bonding states of Ti, Cr and Al. In Figs. 4-6 showing spectra indicating the bonding states of Ti, Cr and Al at each depth, the axis of abscissa indicates bonding energy (eV), and the axis of ordinates indicates c/s (count per second). It was confirmed that any bonding states of Ti, Cr and Al were substantially the same at three measurement positions.

Fig. 4 shows peaks of TiNxOy and T-N, Fig. 5 shows peaks of Cr-O and Cr-N, and Fig. 6 shows peaks of Al-N. In the X -ray photoelectron spectrum of Fig. 6, Al-O bonds were not observed, but only Al-N bonds were observed. Though an exact ratio of x to y in TiNxOy was not known from the X-ray photoelectron spectrum of Fig. 4, it was confirmed from the EPMA values of the (AlTiCr)NO coating (see the column of Example 1 in Table 2-2 below) that TiNxOy is nitride-based Ti oxynitride. In Fig. 5, a Cr-N peak existed near 575 eV, and a gently sloping Cr-O peak existed near 585 eV. It was confirmed from Figs. 4-6 that the (AlTiCr)NO contained Cr-O, with the oxidation of Ti and Al suppressed.

(5) X-ray diffraction pattern of (AlTiCr)NO coating

To observe the crystal structure of the (AlTiCr)NO coating on the property-evaluating insert substrate, an X-ray diffraction pattern (Fig. 7) was obtained by $CuK\alpha_1$ rays (wavelength $\lambda$: 0.15405 nm) irradiated from an X-ray diffraction apparatus (EMPYREAN available from Panalytical) under the following conditions:

Tube voltage: 45 kV,
Tube current: 40 mA,
Incident angle $\omega$: fixed at 3°, and
$2\theta$: 30-80°.

In Fig. 7, X-ray diffraction peaks at planes of (111), (200), (220), (311) and (222) are assigned to the NaCl-type structure. It was thus confirmed that the (AlTiCr)NO coating of Example 1 had only an NaCl-type structure.

Table 1 shows standard X-ray diffraction intensities $I_0$ and $2\theta$ of TiN described in ICCD Reference Code 00-038-1420. TiN has the same NaCl-type structure as that of (AlTiCr)NO. Because the (AlTiCr)NO coating of the present invention is a solid solution obtained by substituting part of Ti in TiN by Al and Cr and adding O, the numbers shown in Table 1 were used as standard X-ray diffraction intensities $I_0$ (hkl).

Table 1

| Miller Index | $I_0$ | $2\theta$ (°) |
|---|---|---|
| (111) | 72 | 36.66 |
| (200) | 100 | 42.60 |
| (220) | 45 | 61.82 |
| (311) | 19 | 74.07 |
| (222) | 12 | 77.96 |

The X-ray diffraction pattern of Fig. 7 indicates that the peak angles $2\theta$ of the (AlTiCr)NO coating were shifted toward a higher angle side than in Table 1, presumably because strain was generated in the (AlTiCr)NO coating by the addition of other elements such as Al, etc. to TiN.

(6) Microstructures of modifying layer and (AlTiCr)NO coating

A cross section of the (AlTiCr)NO coating on the property-evaluating insert was observed by TEM (JEM-2100 available from JEOL, Ltd.), near a boundary (interface) of the WC-based cemented carbide substrate, the modifying layer and the (AlTiCr)NO coating. Fig. 8 is a TEM photograph (magnification: 4,500,000 times) of a portion A. The portion A includes the modifying layer 33 between the WC-based cemented carbide substrate 31 and the (AlTiCr)NO coating 32, and a nearby portion in Fig. 3.

In Fig. 9, which is a schematic view of Fig. 8, a line $L_1$ indicates a boundary between the WC-based cemented carbide substrate 31 and the modified layer 33, a line $L_2$ indicates a boundary between the modified layer 33 and the (AlTiCr)NO coating 32. An average thickness $D_1$ of the modified layer 33 in one field can be determined by dividing an area S of the modified layer 33 encircled by the lines $L_1$ line $L_2$ by the length L of the modified layer 33. The average thicknesses $D_1$, $D_2$, $D_3$, $D_4$, $D_5$ of the modified layer 33 in five different fields were determined by the same method, and arithmetically averaged to obtain the average thickness Da of the modified layer 33. The average thickness Da of the modified layer 33 determined by this method was 5 nm.

Using JEM-2100, the nanobeam diffraction of the modified layer 33 was measured substantially at a thickness-direction center in Fig. 8 at acceleration voltage of 200 kV and camera length of 50 cm. The resultant diffraction image is shown in Fig. 10. The nanobeam diffraction of the (AlTiCr)NO coating 32 was also measured at a thickness-direction center in Fig. 8 under the same conditions. The resultant diffraction image is shown in Fig. 11. Fig. 10 indicates that the modified layer formed by ion bombardment with a $Ti_{0.85}O_{0.15}$ target had an fcc structure. Fig. 11 indicates that the (AlTiCr)NO coating of the present invention also had an fcc structure.

The qualitative analysis of the composition of the modified layer 33 at a thickness-direction center in Fig. 8 was conducted by a UTW-type Si (Li) semiconductor detector attached to JEM-2100, at a beam diameter of 1 nm. The resultant spectrum is shown in Fig. 12. In Fig. 12, the axis of abscissa indicates keV, and the axis of ordinates indicates counts (accumulated intensity). Fig. 12 indicates that the modified layer 33 is a compound comprising at least Ti, W, C and O.

Using JEM-2100, a selected-field diffraction pattern of the (AlTiCr)NO coating on the property-evaluating insert was obtained at acceleration voltage of 200 kV and camera length of 50 cm. As a result, it was found that the (AlTiCr)NO coating on the property-evaluating insert had an NaCl-type structure as a main structure and a wurtzite-type structure as a sub-structure.

(7) Measurement of tool life

As shown in Fig. 14, four high-feed milling inserts 30 each having the (AlTiCr)NO coating were fixed to a tip end portion 38 of a tool body 36 of an indexable rotary cutting tool (ASR5063-4 available from Mitsubishi Hitachi Tool Engineering, Ltd.) 40 by screws 47. The tool 40 had an edge diameter of 63 mm. The inserts 30 used for cutting under the following milling conditions were collected every unit time to observe their flanks 36 by an optical microscope (magnification: 100 times). The cutting time when the wear width or chipping width of each flank 36 reached 0.3 mm or more was judged as a tool life.

Cutting conditions

| | |
|---|---|
| Cutting method: | High-feed, continuous milling, |
| Work: | S50C rod of 123 mm x 250 mm having a rectangular cross section, |
| Insert used: | EDNW15T4TN-15 (milling), |
| Cutting tool: | ASR5063-4, |
| Cutting speed: | 200 m/minute, |
| Feed per one blade: | 1.83 mm/edge, |
| Axial cutting depth: | 1.0 mm, |
| Radial cutting depth: | 42.5 mm, and |
| Cutting liquid: | No (dry cutting). |

The composition of each target used for forming the (AlTiCr)NO coating is shown in Table 2-1, the composition of each (AlTiCr)NO coating is shown in Table 2-2, and the crystal structure measured by X-ray diffraction and electron diffraction, the existence of Al-O bonds and Cr-O bonds, and the life of each tool are shown in Table 2-3.

Example 2-9, and Comparative Example 1

A hard coating was formed on each milling insert and evaluated in the same manner as in Example 1, except for using a target for forming a coating having the composition shown in Table 2-1. The composition of each target is shown in Table 2-1; the composition of each coating is shown in Table 2-2; and the crystal structure of each coating measured by X-ray diffraction and electron beam diffraction, the existence of Al-O bonds and Cr-O bonds in each coating, and the life of each tool are shown in Table 2-3.

Table 2-1

| No. | Composition of Target (atomic ratio) | | | | | |
|---|---|---|---|---|---|---|
| | Al (P) | AlN (q) | Ti (r) | TiN (s) | CrN (t) | $Cr_2O_3$ (u) |
| Example 1 | 0.70 | 0.06 | 0.09 | 0.09 | 0.03 | 0.03 |
| Example 2 | 0.75 | 0.05 | 0.05 | 0.06 | 0.04 | 0.05 |
| Example 3 | 0.61 | 0.04 | 0.20 | 0.08 | 0.04 | 0.03 |
| Example 4 | 0.59 | 0.05 | 0.17 | 0.13 | 0.03 | 0.03 |
| Example 5 | 0.72 | 0.05 | 0.04 | 0.03 | 0.13 | 0.03 |
| Example 6 | 0.65 | 0.05 | 0.05 | 0.08 | 0.13 | 0.04 |
| Example 7 | 0.70 | 0.06 | 0.10 | 0.11 | 0.01 | 0.02 |
| Example 8 | 0.71 | 0.06 | 0.05 | 0.07 | 0.03 | 0.08 |
| Example 9 | 0.68 | 0.07 | 0.09 | 0.09 | 0.06 | 0.01 |
| Com. Ex. 1 | 0.73 | 0.06 | 0.09 | 0.09 | 0.03 | 0.00 |

Table 2-2

| No. | Coating | Composition of (AlTiCr)NO Coating (atomic ratio) | | | | | |
|---|---|---|---|---|---|---|---|
| | | Al (x) | Ti (y) | Cr (z) | AlTiCr (a) | N (1-a-b) | O (b) |
| Example 1 | (AlTiCr)NO | 0.70 | 0.22 | 0.08 | 0.47 | 0.47 | 0.06 |
| Example 2 | (AlTiCr)NO | 0.75 | 0.13 | 0.12 | 0.47 | 0.46 | 0.07 |
| Example 3 | (AlTiCr)NO | 0.61 | 0.31 | 0.08 | 0.46 | 0.48 | 0.06 |
| Example 4 | (AlTiCr)NO | 0.59 | 0.34 | 0.07 | 0.45 | 0.48 | 0.07 |
| Example 5 | (AlTiCr)NO | 0.73 | 0.09 | 0.18 | 0.48 | 0.45 | 0.07 |
| Example 6 | (AlTiCr)NO | 0.65 | 0.15 | 0.20 | 0.45 | 0.47 | 0.08 |
| Example 7 | (AlTiCr)NO | 0.70 | 0.26 | 0.04 | 0.48 | 0.46 | 0.06 |
| Example 8 | (AlTiCr)NO | 0.72 | 0.15 | 0.13 | 0.47 | 0.44 | 0.09 |
| Example 9 | (AlTiCr)NO | 0.70 | 0.22 | 0.08 | 0.50 | 0.46 | 0.04 |
| Com. Ex. 1 | (AlTiCr)N | 0.71 | 0.21 | 0.08 | 0.51 | 0.49 | 0.00 |

Table 2-3

| No. | (AlTiCr)NO coating | | | | Tool Life (minute) |
|---|---|---|---|---|---|
| | Crystal Structure | | Al-O Bonds(3) | Cr-O Bonds | |
| | X-ray Diffraction | Electron Diffraction | | | |
| Example 1 | NaCl-type (1) | NaCl-type (2) | No | Yes | 53 |
| Example 2 | NaCl-type (1) | NaCl-type (2) | No | Yes | 46 |
| Example 3 | NaCl-type (1) | NaCl-type (2) | No | Yes | 42 |
| Example 4 | NaCl-type (1) | NaCl-type (2) | No | Yes | 41 |
| Example 5 | NaCl-type (1) | NaCl-type (2) | No | Yes | 35 |
| Example 6 | NaCl-type (1) | NaCl-type (2) | No | Yes | 42 |

(continued)

| No. | (AlTiCr)NO coating | | | | Tool Life (minute) |
|---|---|---|---|---|---|
| | Crystal Structure | | Al-O Bonds(3) | Cr-O Bonds | |
| | X-ray Diffraction | Electron Diffraction | | | |
| Example 7 | NaCl-type (1) | NaCl-type (2) | No | Yes | 33 |
| Example 8 | NaCl-type (1) | NaCl-type (2) | No | Yes | 45 |
| Example 9 | NaCl-type (1) | NaCl-type (2) | No | Yes | 31 |
| Com. Ex. 1 | NaCl-type (1) | NaCl-type (2) | Yes | No | 15 |

Note: (1) Single structure.
(2) Main structure.
(3) The existence of Al-O bonds exceeding an inevitable impurity level.

As shown in Table 2-3, it was confirmed by X-ray photoelectron spectrum that each hard coating of Examples 1-9 had Cr-O bonds without Al-O bonds exceeding an inevitable impurity level. Accordingly, each hard-coated insert of Examples 1-9 had as long a life as 31 minutes or more. On the other hand, the hard-coated insert of Comparative Example 1 formed by using the (AlTiCr)N target had as short a life as 15 minutes. The reason therefor is that the hard coating of Comparative Example 1 had poor oxidation resistance and wear resistance, because of no Cr-O bonds though it had Al-O bonds exceeding an inevitable impurity level.

Example 10

An (AlTiCr)NO coating was formed on the same WC-based cemented carbide substrate as in Example 1, and evaluated in the same manner as in Example 1, except for forming no modifying layer. As a result, the tool life was 28 minutes, longer than that in Comparative Example 1.

Example 11

In the AI apparatus of Fig. 1, a target 10 having a composition of $Ti_{0.8}B_{0.2}$ (atomic ratio) was set on the arc discharge evaporation source 13 connected to the arc discharge power source 11, and the same high-feed milling insert substrate and property-evaluating insert substrate of WC-based cemented carbide as in Example 1 were placed on the upper holder 8. Each substrate was cleaned with argon ions in the same manner as in Example 1. A modifying layer having an average thickness of 5 nm was then formed on each substrate kept at 610°C at an argon gas flow rate of 50 sccm, with DC bias voltage of -750 V applied to each substrate from the bias power source 3, and with DC arc current of 80 A supplied to the target 10 from the arc discharge power source 11. An (AlTiCr)NO coating was subsequently formed on the milling insert and evaluated in the same manner as in Example 1. As a result, the tool life was 56 minutes, longer than that in Example 1 (53 minutes).

Example 12

(1) Cleaning of substrate, and formation of modifying layer with TiO target

The same high-feed milling insert substrate (EDNW15T4TN-15) and property-evaluating insert substrate (SNMN120408) of WC-based cemented carbide as in Example 1 were cleaned by argon ion bombardment, and provided with a modifying layer using a TiO target in the same manner as in Example 1.

(2) Formation of (AlTiNb)NO coating

A target 18 having a composition of $(Al)_{0.72}(AlN)_{0.05}(Ti)_{0.10}(TiN)_{0.09}(NbN)_{0.01}(Nb_2O_5)_{0.03}$ (atomic ratio) was set on the arc discharge evaporation source 27 connected to the arc discharge power source 12. With the temperature of the substrate 7 set at 450°C, a nitrogen gas of 800 sccm was introduced into a vacuum chamber 5 to adjust the pressure to 3.1 Pa.

With DC bias voltage of -80 V applied to each substrate from the bias power source 3, and with pulse arc current having a substantially rectangular waveform supplied to the target 18 from the arc discharge power source 12,

a 3-μm-thick coating having a composition of $(Al_{0.69}Ti_{0.24}Nb_{0.07})_{0.45}N_{0.50}O_{0.05}$ (atomic ratio) was formed. The composition of the coating was measured by EPMA (JXA-8500F) in the same manner as in Example 1. As shown in Fig. 2, the pulse arc current had the minimum value $A_{min}$ of 65 A and the maximum value $A_{max}$ of 95 A, a frequency of 5 kHz (period T = 2.0 x $10^{-4}$ second/pulse), and a duty ratio D of 50%.

(3) Bonding states of Ti, Nb and Al in (AlTiNb)NO coating

The bonding states of Ti, Nb and Al were investigated by X-ray photoelectron spectroscopy in the same manner as in Example 1. As a result, it was found that the (AlTiNb)NO coating had Nb-O bonds without Al-O bonds exceeding an inevitable impurity level. This indicates that the oxidation of Ti and Al was suppressed.

(4) X-ray diffraction pattern of (AlTiNb)NO coating

The same X-ray diffraction measurement as in Example 1 revealed that the (AlTiNb)NO coating on the property-evaluating insert substrate had only an NaCl-type structure.

(5) Microstructures of modifying layer and (AlTiNb)NO coating

A cross section of the (AlTiNb)NO coating on the property-evaluating insert was observed by TEM (JEM-2100). As a result, continuous crystal lattice fringes were observed in portions of the boundary between the modifying layer and the (AlTiNb)NO coating. The average thickness of the modifying layer determined by the same method as in Example 1 was 7 nm. Nanobeam diffraction using the same JEM-2100 as in Example 1 revealed that both of the modifying layer and the (AlTiNb)NO coating had an fcc structure.

The selected area diffraction of the (AlTiNb)NO coating of the property-evaluating insert at acceleration voltage of 200 kV and camera length of 50 cm using JEM-2100 revealed that the (AlTiNb)NO coating of the property-evaluating insert had an NaCl-type structure as a main structure and a wurtzite-type structure as a sub-structure.

(6) Measurement of tool life

The tool life was measured in the same manner as in Example 1.

The compositions of targets used for forming the (AlTiNb)NO coatings are shown in Table 3-1, the compositions of the (AlTiNb)NO coatings are shown in Table 3-2, and the crystal structure of the (AlTiNb)NO coating identified by X-ray diffraction and electron diffraction, the existence of Al-O bonds and Nb-O bonds in the (AlTiNb)NO coating, and the life of each tool are shown in Table 3-3.

Examples 13-20, and Comparative Example 2

A hard coating was formed on each milling insert and evaluated in the same manner as in Example 12, except for using a target having the composition shown in Table 3-1 for forming an (AlTiNb)NO coating. The composition of each target is shown in Table 3-1, the composition of each coating is shown in Table 3-2, and the crystal structure of each coating identified by X-ray diffraction and electron diffraction, the existence of Al-O bonds and Nb-O bonds in each coating, and the life of each tool are shown in Table 3-3.

Table 3-1

| No. | Composition of Target (atomic ratio) | | | | | |
|---|---|---|---|---|---|---|
| | Al (p) | AlN (q) | Ti (r) | TiN (s) | NbN (t) | $Nb_2O_5$ (u) |
| Example 12 | 0.72 | 0.05 | 0.10 | 0.09 | 0.01 | 0.03 |
| Example 13 | 0.73 | 0.06 | 0.06 | 0.06 | 0.05 | 0.04 |
| Example 14 | 0.62 | 0.05 | 0.19 | 0.08 | 0.02 | 0.04 |
| Example 15 | 0.59 | 0.05 | 0.17 | 0.13 | 0.02 | 0.04 |
| Example 16 | 0.73 | 0.04 | 0.05 | 0.03 | 0.11 | 0.04 |
| Example 17 | 0.66 | 0.05 | 0.06 | 0.08 | 0.11 | 0.04 |
| Example 18 | 0.69 | 0.06 | 0.09 | 0.11 | 0.02 | 0.03 |

(continued)

| No. | Composition of Target (atomic ratio) | | | | | |
|---|---|---|---|---|---|---|
| | Al (p) | AlN (q) | Ti (r) | TiN (s) | NbN (t) | $Nb_2O_5$ (u) |
| Example 19 | 0.69 | 0.07 | 0.06 | 0.07 | 0.05 | 0.06 |
| Example 20 | 0.69 | 0.06 | 0.10 | 0.09 | 0.04 | 0.02 |
| Com. Ex. 2 | 0.75 | 0.05 | 0.10 | 0.09 | 0.01 | 0.00 |

Table 3-2

| No. | Coating | Composition of (AlTiNb)NO Coating (atomic ratio) | | | | | |
|---|---|---|---|---|---|---|---|
| | | Al (x) | Ti (y) | Nb (z) | AlTiNb (a) | N (1-a-b) | O (b) |
| Example 12 | (AlTiNb)NO | 0.69 | 0.24 | 0.07 | 0.45 | 0.50 | 0.05 |
| Example 13 | (AlTiNb)NO | 0.73 | 0.13 | 0.14 | 0.48 | 0.46 | 0.06 |
| Example 14 | (AlTiNb)NO | 0.60 | 0.29 | 0.11 | 0.49 | 0.44 | 0.07 |
| Example 15 | (AlTiNb)NO | 0.60 | 0.31 | 0.09 | 0.48 | 0.46 | 0.06 |
| Example 16 | (AlTiNb)NO | 0.70 | 0.10 | 0.20 | 0.48 | 0.45 | 0.07 |
| Example 17 | (AlTiNb)NO | 0.67 | 0.15 | 0.18 | 0.46 | 0.47 | 0.07 |
| Example 18 | (AlTiNb)NO | 0.69 | 0.23 | 0.08 | 0.47 | 0.47 | 0.06 |
| Example 19 | (AlTiNb)NO | 0.71 | 0.14 | 0.15 | 0.47 | 0.43 | 0.10 |
| Example 20 | (AlTiNb)NO | 0.71 | 0.24 | 0.05 | 0.49 | 0.48 | 0.03 |
| Com. Ex. 2 | (AlTiNb)N | 0.70 | 0.23 | 0.07 | 0.49 | 0.51 | 0.00 |

Table 3-3

| No. | (AlTiNb)NO Coating | | | | Tool Life (minute) |
|---|---|---|---|---|---|
| | Crystal Structure | | Al-O Bonds(3) | Nb-O Bonds | |
| | X-Ray Diffraction | Electron Diffraction | | | |
| Example 12 | NaCl-Type(1) | NaCl-Type(2) | No | Yes | 50 |
| Example 13 | NaCl-Type(1) | NaCl-Type(2) | No | Yes | 45 |
| Example 14 | NaCl-Type(1) | NaCl-Type(2) | No | Yes | 41 |
| Example 15 | NaCl-Type(1) | NaCl-Type(2) | No | Yes | 39 |
| Example 16 | NaCl-Type(1) | NaCl-Type(2) | No | Yes | 34 |
| Example 17 | NaCl-Type(1) | NaCl-Type(2) | No | Yes | 40 |
| Example 18 | NaCl-Type(1) | NaCl-Type(2) | No | Yes | 32 |
| Example 19 | NaCl-Type(1) | NaCl-Type(2) | No | Yes | 42 |
| Example 20 | NaCl-Type(1) | NaCl-Type(2) | No | Yes | 32 |
| Com. Ex. 2 | NaCl-Type(1) | NaCl-Type(2) | Yes | No | 14 |

Note: (1) Single structure.
(2) Main structure.
(3) The existence of Al-O bonds exceeding an inevitable impurity level.

As shown in Table 3-3, it was confirmed by X-ray photoelectron spectrum that each hard coating of Examples 12-20 had Cr-O bonds without Al-O bonds exceeding an inevitable impurity level. Accordingly, each hard-coated insert of Examples 12-20 had as long a life as 32 minutes or more. On the other hand, the hard-coated insert of Comparative Example 2 formed by using the (AlTiNb)N target had as short a life as 14 minutes. The reason therefor is that the hard coating of Comparative Example 2 had poor oxidation resistance and wear resistance because of no Nb-O bonds though it had Al-O bonds exceeding an inevitable impurity level.

Example 21

An (AlTiNb)NO coating was formed on the same WC-based cemented carbide substrate as in Example 1 in the same manner as in Example 12 except for forming no modifying layer, and evaluated. As a result, the tool life was 26 minutes, longer than that in Comparative Example 2.

Example 22

In the AI apparatus of Fig. 1, a target 10 having a composition of $Ti_{0.8}B_{0.2}$ (atomic ratio) was set on the arc discharge evaporation source 13 connected to the arc discharge power source 11, and the same high-feed milling insert substrate and property-evaluating insert substrate of WC-based cemented carbide as in Example 1 were placed on the upper holder 8. Each substrate was cleaned with argon ions in the same manner as in Example 1. A modifying layer having an average thickness of 5 nm was then formed on each substrate kept at 610°C at an argon gas flow rate of 50 sccm, with DC bias voltage of -750 V applied to each substrate from the bias power source 3, and with DC arc current of 80 A supplied to the target 10 from the arc discharge power source 11. Thereafter, an (AlTiNb)NO coating was formed on the milling insert and evaluated in the same manner as in Example 12. As a result, the tool life was 52 minutes, longer than that in Example 12 (50 minutes).

Example 23

A modifying layer, and a 1.5-μm-thick (AlTiCr)NO coating having a composition of $(Al_{0.71}Ti_{0.21}Cr_{0.08})_{0.46}N_{0.48}O_{0.06}$ (atomic ratio) were formed on the same high-feed milling insert substrate and property-evaluating insert substrate of WC-based cemented carbide as in Example 1, in the same manner as in Example 1 except for changing the time of forming the (AlTiCr)NO coating. A 1.5-μm-thick coating having a composition of $(Al_{0.70}Ti_{0.24}Nb_{0.06})_{0.46}N_{O.49}O_{0.05}$ (atomic ratio) was then formed immediately on the (AlTiCr)NO coating in the same manner as in Example 12 except for changing the forming time. The resultant multi-layer coating had a composition of (AlTiCrNb)NO as a whole. The tool life measured in the same manner as in Example 12 was as long as 52 minutes.

DESCRIPTION OF REFERENCE NUMERALS

1: Driving means
2: Gas inlet
3: Bias power source
4: Bearing
5: Vacuum chamber
6: Lower holder (support)
7: Substrate
8: Upper holder
10: Cathode material (target)
11, 12: Arc discharge power source
13, 27: Arc discharge evaporation source
14: Insulator for fixing arc discharge evaporation source
15: Bearing for arc ignition mechanism
16: Arc ignition mechanism
17: Gas outlet
18: Cathode material (target)
19: Electrode-fixing insulator
20: Electrode
21: Shield plate bearing
22: Shield plate-operating means

23: Shield plate
30: Milling insert
31: WC-based cemented carbide substrate
32: (AlTiCr)NO coating
33: Modifying layer
35: Main cutting edge of insert
36: Flank of insert
40: Indexable rotary cutting tool
46: Tool body
47: Insert-fixing screw
48: Tip end portion of tool body

## Claims

1. A hard coating having a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively;
said hard coating having M-O bonds without Al-O bonds exceeding an inevitable impurity level as a bonding state identified by X-ray photoelectron spectroscopy, and having only an NaCl-type structure in its X-ray diffraction pattern.

2. The hard coating according to claim 1, wherein said hard coating has an NaCl-type structure as a main structure and a wurtzite-type structure as a sub-structure in its electron diffraction pattern.

3. A hard-coated member having the hard coating of claim 1 or 2 formed on a substrate.

4. A method for producing a hard-coated member having a hard coating formed on a substrate by arc ion plating; said hard coating having a composition represented by $(Al_xTi_yM_z)_aN_{(1-a-b)}O_b$, wherein M is at least one element of Cr and Nb, and x, y, z, a and b are numbers meeting by atomic ratio $0.6 \leq x \leq 0.8$, $0.05 \leq y \leq 0.38$, $0.02 \leq z \leq 0.2$, $x + y + z = 1$, $0.2 \leq a \leq 0.8$, and $0.02 \leq b \leq 0.10$, respectively, and having M-O bonds without Al-O bonds exceeding an inevitable impurity level as a bonding state identified by X-ray photoelectron spectroscopy, and having only an NaCl-type structure in its X-ray diffraction pattern; comprising
using a target having a composition represented by $(Al)_p(AlN)_q(Ti)_r(TiN)_s(MN)_t(MO_x)_u$, wherein M is at least one element of Cr and Nb; p, q, r, s, t and u are numbers meeting by atomic ratio $0.59 \leq p \leq 0.8$, $0.01 \leq q \leq 0.1$, $0.04 \leq r \leq 0.35$, $0.03 \leq s \leq 0.15$, $0.01 \leq t \leq 0.20$, $0.01 \leq u \leq 0.1$, and $p + q + r + s + t + u = 1$, respectively; and x is a number of 1-2.5 by atomic ratio, in a nitriding gas atmosphere.

5. The method for producing a hard-coated member according to claim 4, wherein
said substrate is kept at a temperature of 400-550°C in a nitriding gas atmosphere;
DC bias voltage or unipolar pulse bias voltage of -270 V to -20 V is applied to said substrate;
pulse arc current is supplied to said target set on an arc discharge evaporation source; and
said pulse arc current has a substantially rectangular waveform having the maximum arc current of 90-120 A and the minimum arc current of 50-90 A, difference between said maximum arc current and said minimum arc current being 10 A or more, a frequency of 2-15 kHz, and a duty ratio of 40-70%.

6. The method for producing a hard-coated member according to claim 4 or 5, wherein
said substrate is made of WC-based cemented carbide; and
before forming said hard coating, negative DC voltage of -850 V to -500 V is applied to said substrate kept at a temperature of 400-700°C, and arc current of 50-100 A is supplied to a target set on an arc discharge evaporation source, said target having a composition of $Ti_eO_{1-e}$, wherein e is a number representing the atomic ratio of Ti, which meets $0.7 \leq e \leq 0.95$, thereby subjecting a surface of said substrate to bombardment with ions generated from said target in an argon gas atmosphere having a flow rate of 30-150 sccm.

7. The method for producing a hard-coated member according to claim 4 or 5, wherein
said substrate is made of WC-based cemented carbide; and
before forming said hard coating, negative DC voltage of -1000 V to -600 V is applied to said substrate kept at a temperature of 450-750°C, and arc current of 50-100 A is supplied to a target set on an arc discharge evaporation source, said target having a composition of $Ti_fB_{1-f}$, wherein f is a number representing the atomic ratio of Ti, which

meets $0.5 \leq f \leq 0.9$, thereby subjecting a surface of said substrate to bombardment with ions generated from said target in an argon gas atmosphere having a flow rate of 30-150 sccm.

**8.** A target used for forming the hard coating recited in claim 1 or 2, wherein said target is a sintered body having a composition represented by $(Al)_p(AlN)_q(Ti)_r(TiN)_s(MN)_t(MO_x)_u$, wherein M is at least one element of Cr and Nb; p, q, r, s, t and u are numbers meeting by atomic ratio $0.59 \leq p \leq 0.8$, $0.01 \leq q \leq 0.1$, $0.04 \leq r \leq 0.35$, $0.03 \leq s \leq 0.15$, $0.01 \leq t \leq 0.20$, $0.01 \leq u \leq 0.1$, and $p + q + r + s + t + u = 1$, respectively; and x is a number of 1-2.5 by atomic ratio.

**9.** A method for producing the target recited in claim 8, wherein a mixture powder comprising AlTi alloy powder, AlN powder, TiN powder, MN powder, and $MO_x$ powder, wherein M is at least one element of Cr and Nb, is hot-pressed in vacuum to obtain said sintered body.

**10.** The method for producing a target according to claim 9, wherein said MN powder is CrN powder, and said $MO_x$ powder is at least one of $Cr_2O_3$ powder, CrO powder and $CrO_2$ powder.

**11.** The method for producing a target according to claim 9, wherein said MN powder is NbN powder, and said $MO_x$ powder is at least one of $Nb_2O_5$ powder, NbO powder, $Nb_2O_3$ powder and $NbO_2$ powder.

# Fig. 1

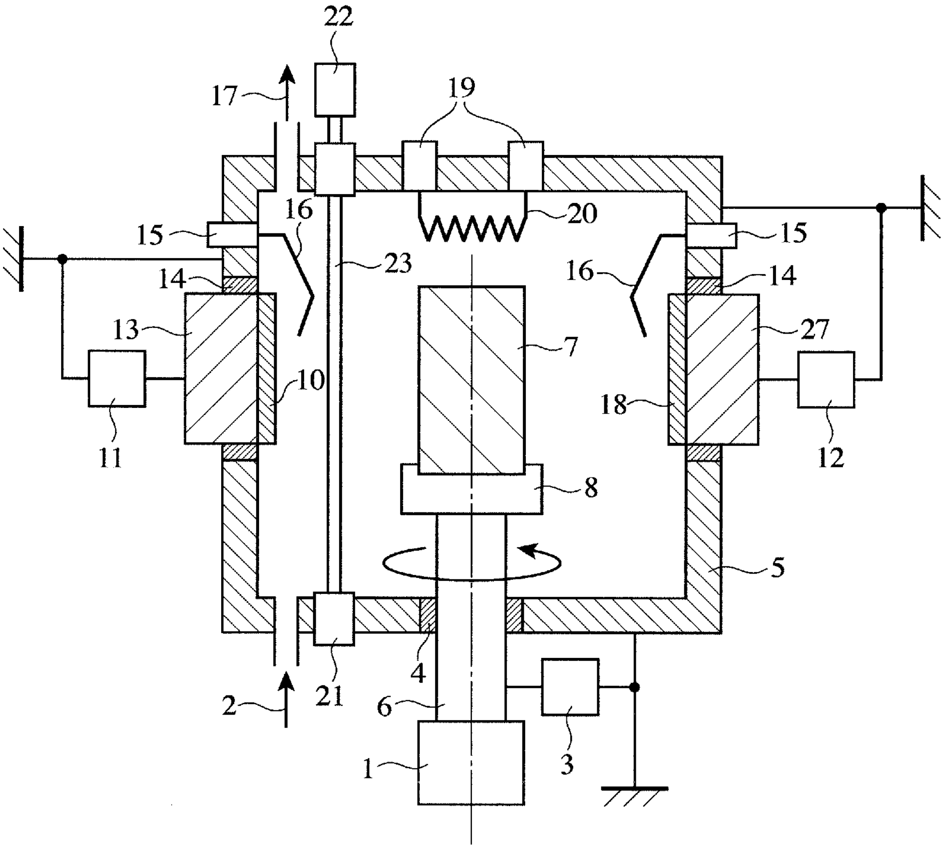
22
17
19
16
20
15
23
15
14
16
14
13
7
27
10
18
11
12
8
5
4
21
2
6
3
1

# Fig. 2

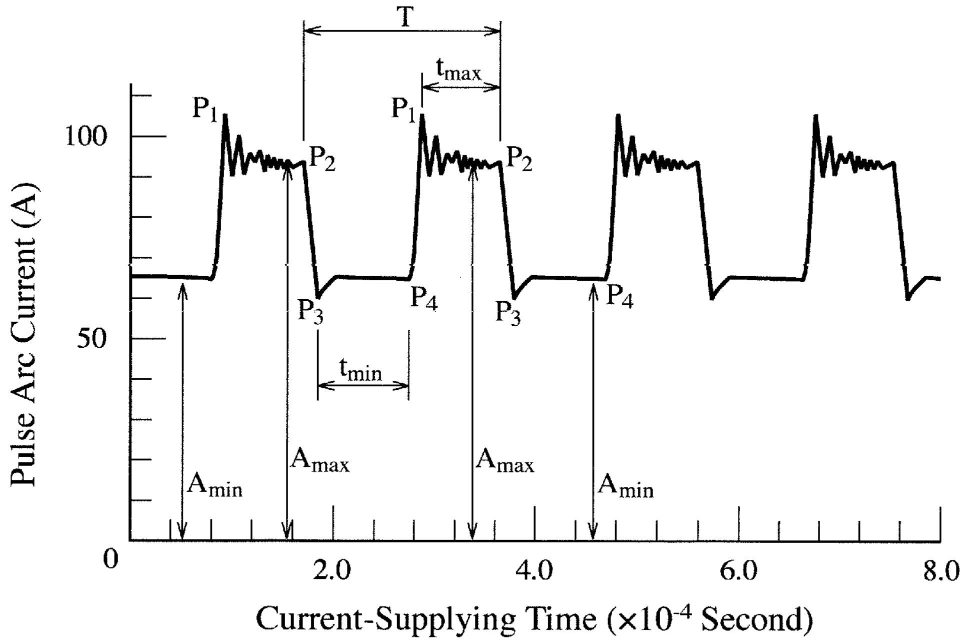
T
$t_{max}$
$P_1$
$P_1$
100
$P_2$
$P_2$
Pulse Arc Current (A)
$P_3$
$P_4$
$P_3$
$P_4$
50
$t_{min}$
$A_{max}$
$A_{max}$
$A_{min}$
$A_{min}$
0
2.0
4.0
6.0
8.0
Current-Supplying Time (×$10^{-4}$ Second)

Fig. 3

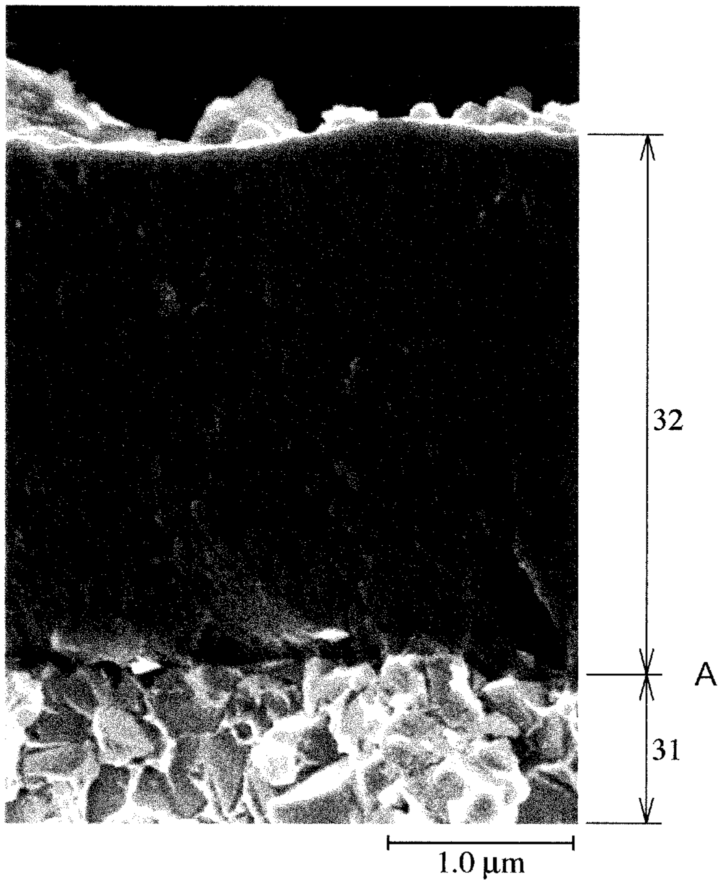
32
A
31
1.0 μm

Fig. 4

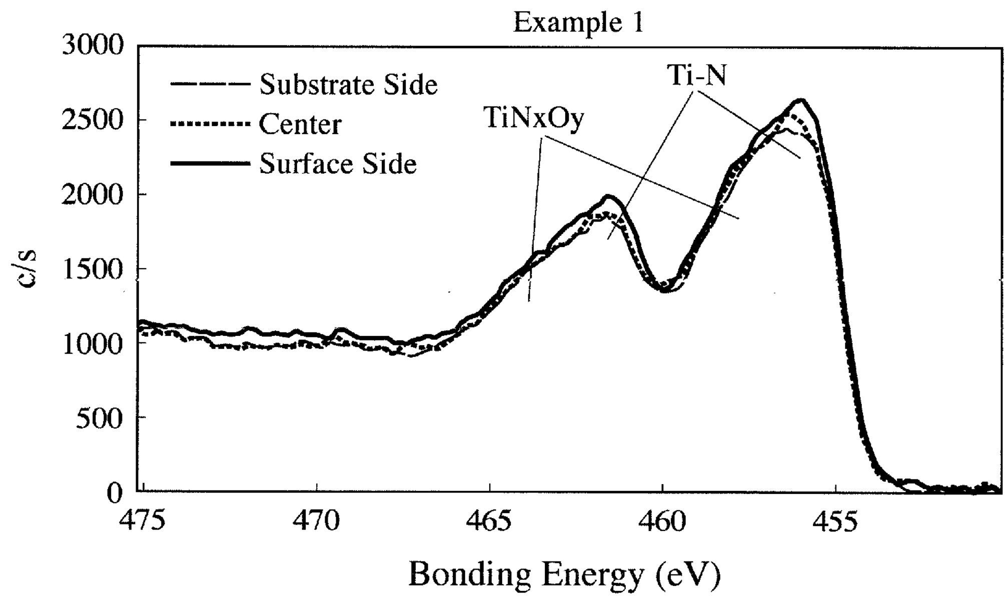
Example 1
Substrate Side
Center
Surface Side
Ti-N
TiNxOy
c/s
3000
2500
2000
1500
1000
500
0
475
470
465
460
455
Bonding Energy (eV)

# Fig. 5

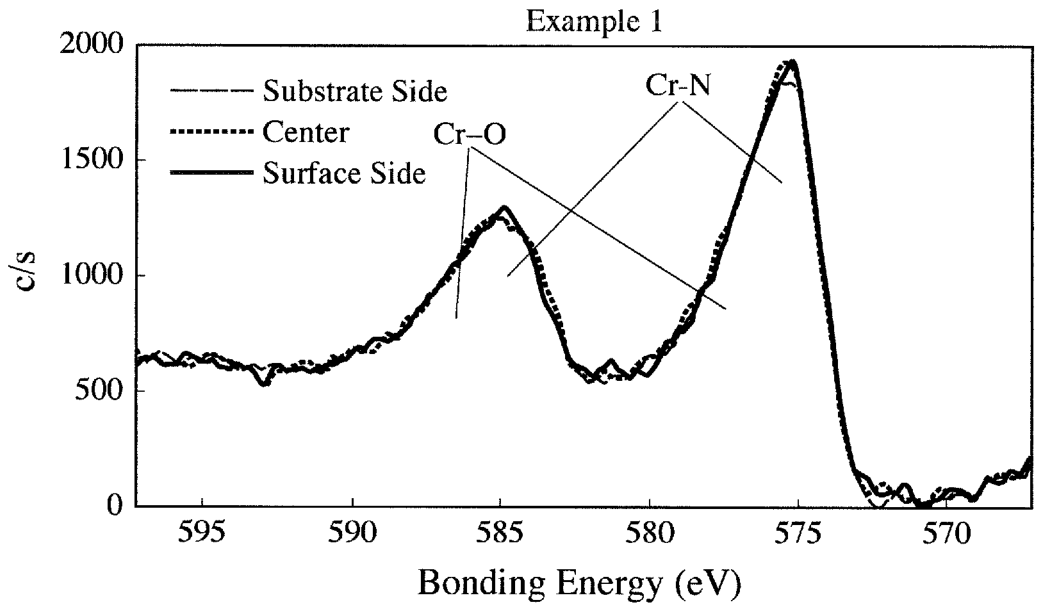
Example 1
Substrate Side
Center
Surface Side
Cr-N
Cr–O
2000
1500
1000
500
0
c/s
595
590
585
580
575
570
Bonding Energy (eV)

# Fig. 6

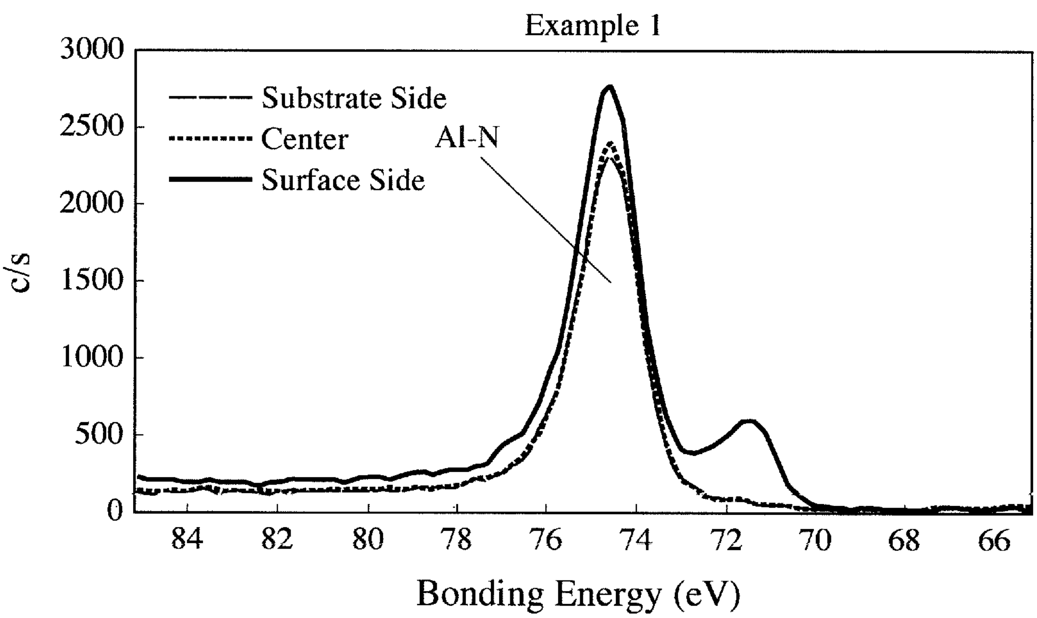
Example 1
Substrate Side
Center
Surface Side
Al-N
3000
2500
2000
1500
1000
500
0
c/s
84
82
80
78
76
74
72
70
68
66
Bonding Energy (eV)

Fig. 7

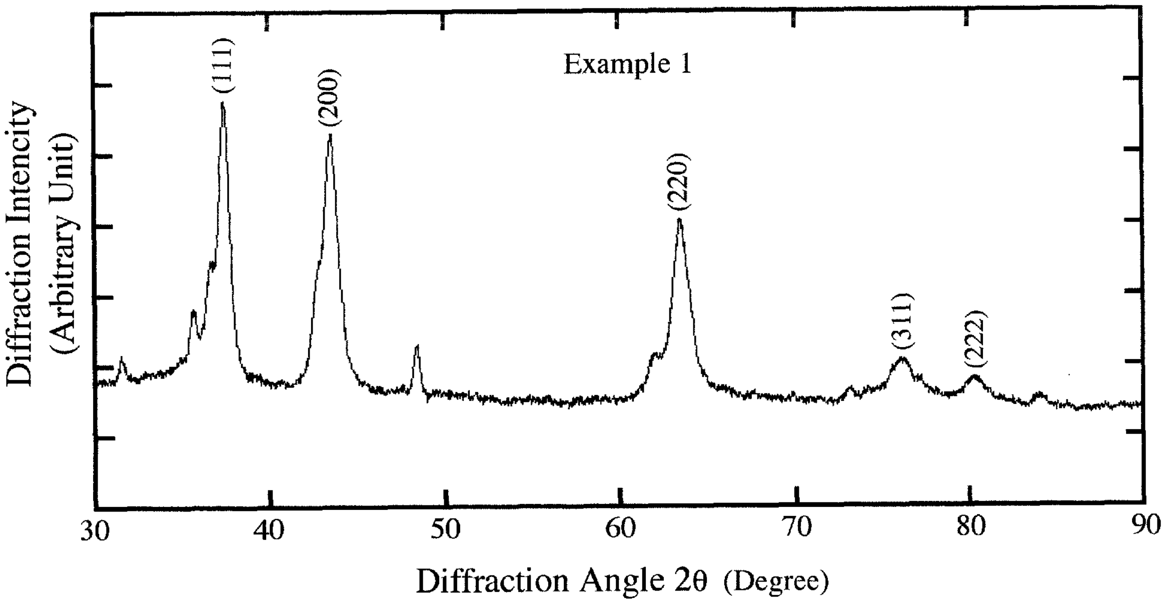
Example 1
(111)
(200)
(220)
(311)
(222)
Diffraction Intencity
(Arbitrary Unit)
30
40
50
60
70
80
90
Diffraction Angle 2θ (Degree)

Fig. 8

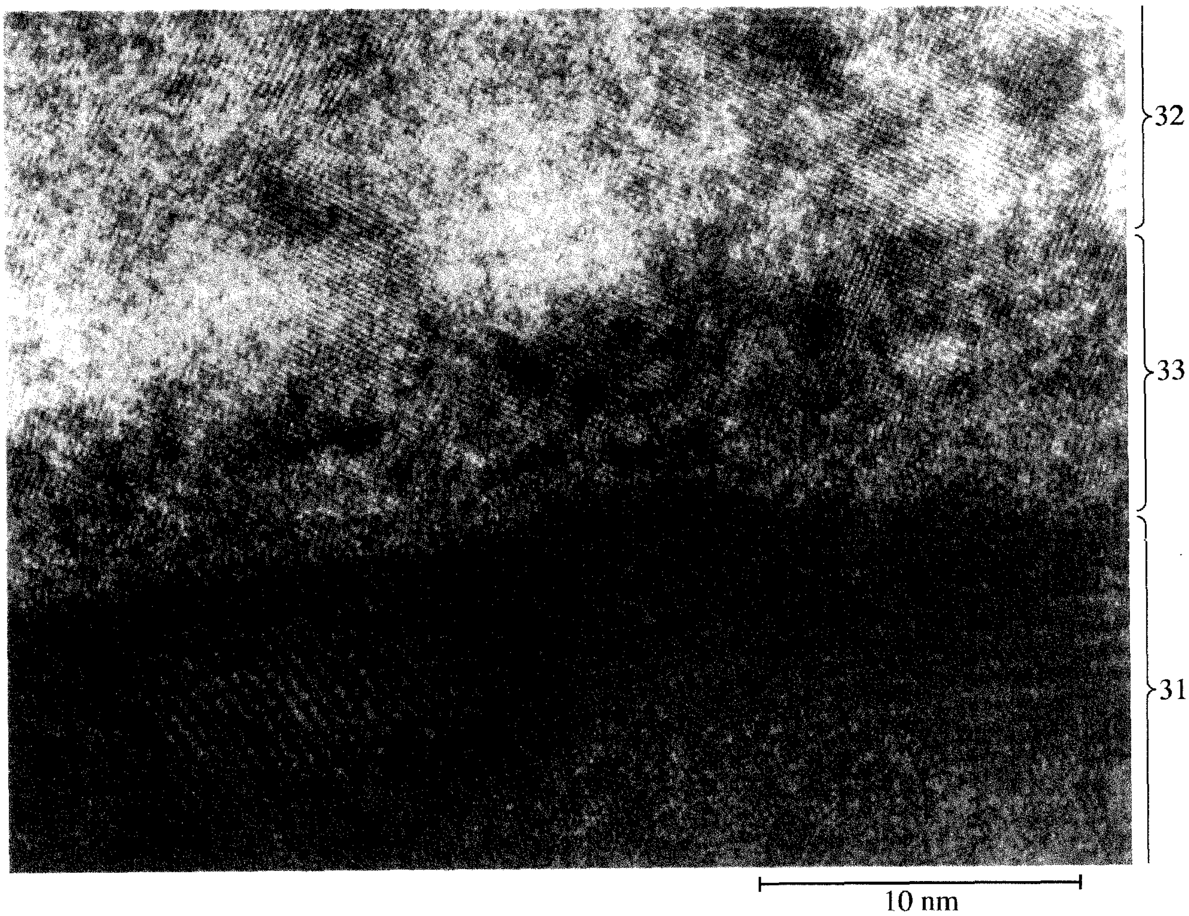
32
33
31
10 nm

Fig. 9

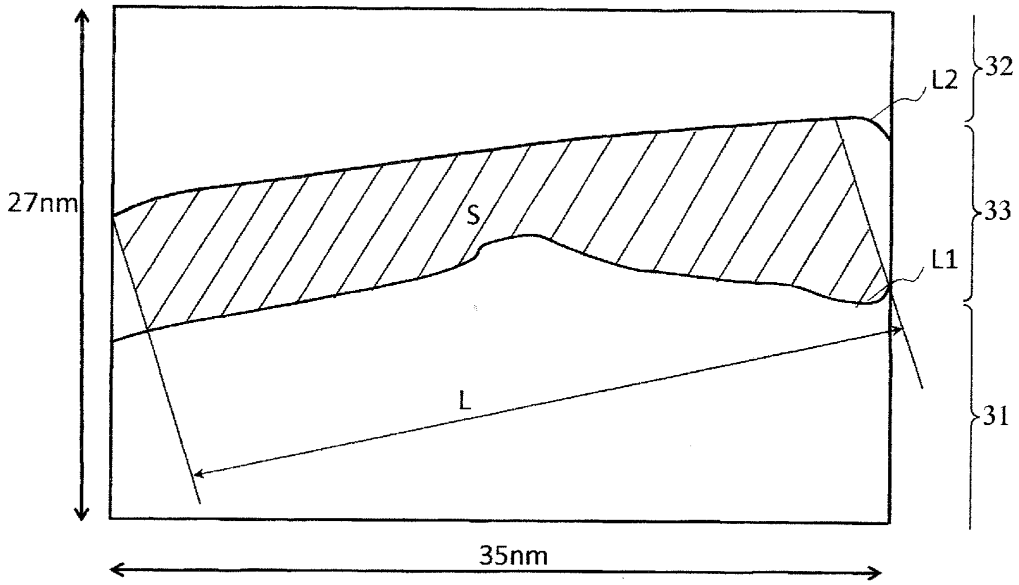


Fig. 10

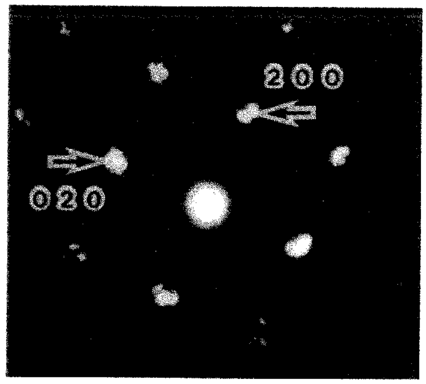


Fig. 11

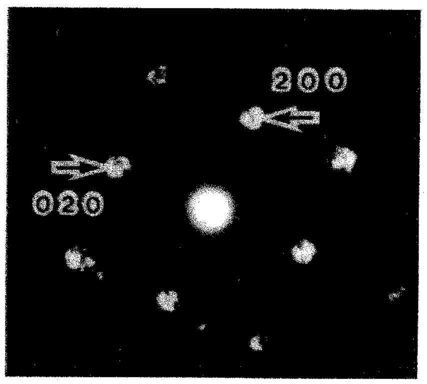

# Fig. 12

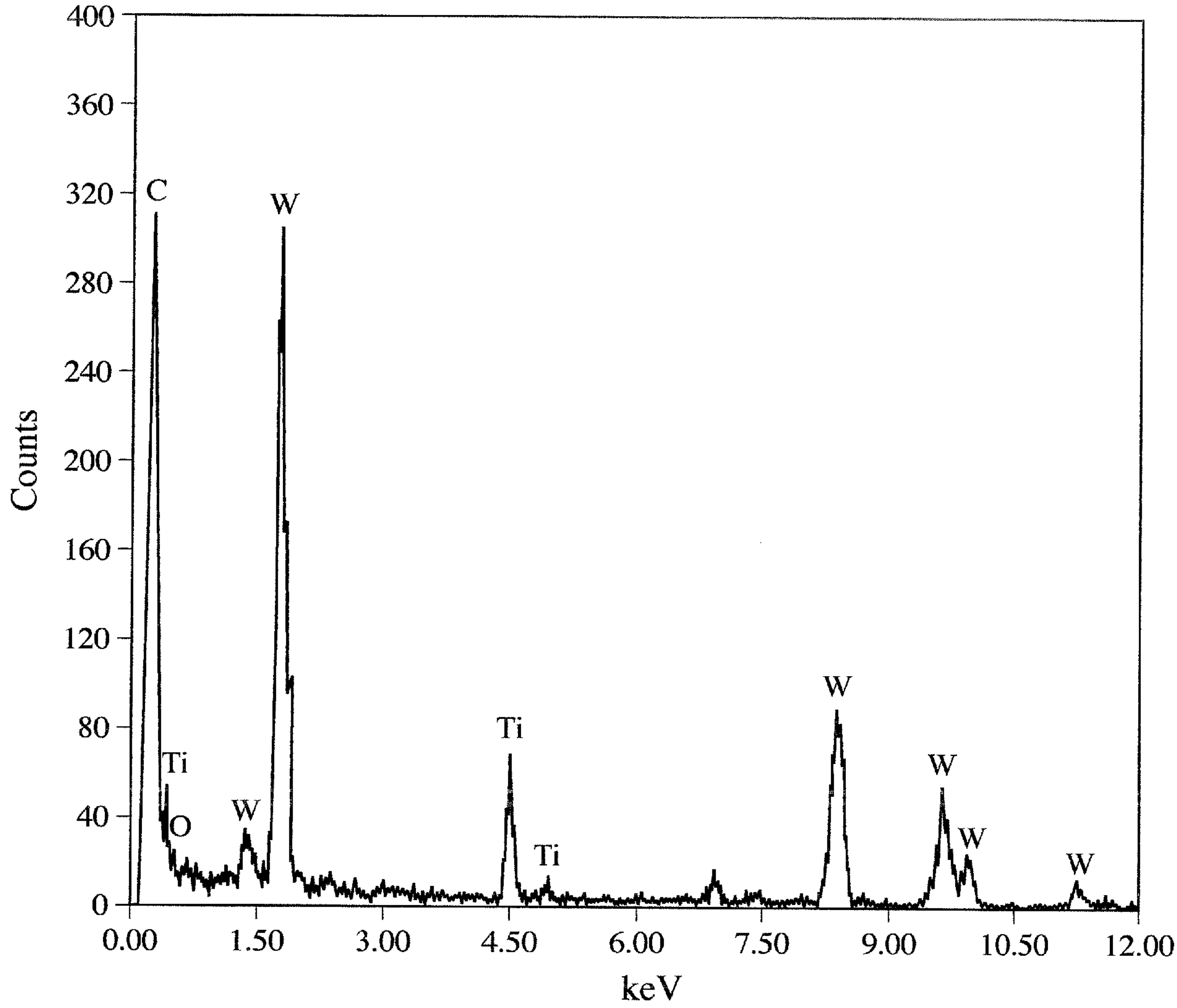
400
360
320
280
240
200
160
120
80
40
0
Counts
C
W
Ti
O
W
Ti
Ti
W
W
W
W
0.00
1.50
3.00
4.50
6.00
7.50
9.00
10.50
12.00
keV

Fig. 13

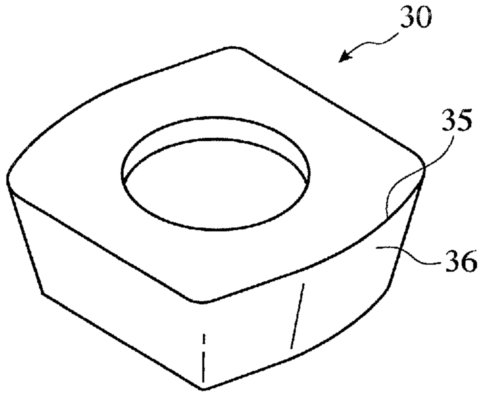


Fig. 14

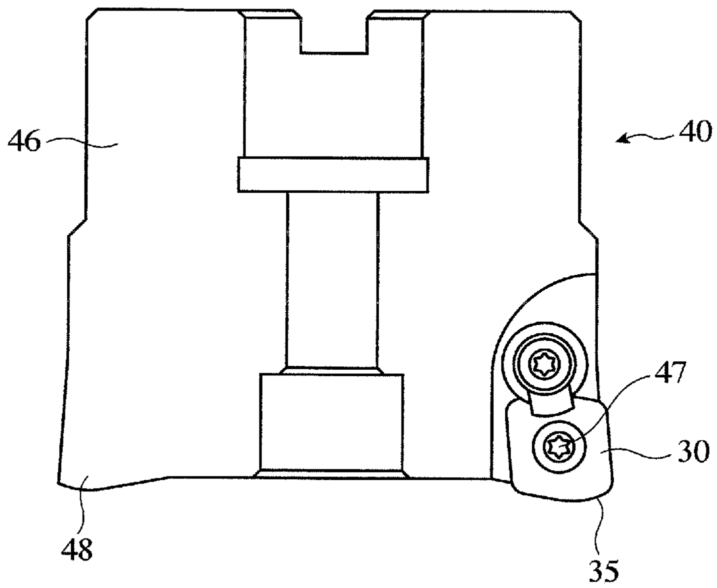

**INTERNATIONAL SEARCH REPORT**

International application No. PCT/JP2016/082794

A. CLASSIFICATION OF SUBJECT MATTER
*C23C14/06*(2006.01)i, *B23B27/14*(2006.01)i, *C23C14/02*(2006.01)i, *C23C14/32*(2006.01)i, *C22C29/08*(2006.01)n

According to International Patent Classification (IPC) or to both national classification and IPC

B. FIELDS SEARCHED

Minimum documentation searched (classification system followed by classification symbols)
C23C14/06, B23B27/14, C23C14/02, C23C14/32, C22C29/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
JSTPlus/JST7580(JDreamIII), CAplus(STN)

C. DOCUMENTS CONSIDERED TO BE RELEVANT

| Category* | Citation of document, with indication, where appropriate, of the relevant passages | Relevant to claim No. |
|---|---|---|
| A | JP 2001-254187 A (Hitachi Tool Engineering Ltd.), 18 September 2001 (18.09.2001), claim 2; paragraph [0004]; table 1, sample no. 4 (Family: none) | 1-11 |
| A | US 2003/0124391 A1 (METAPLAS IONON), 03 July 2003 (03.07.2003), claim 5; paragraphs [0011] to [0013]; No.14 of chart 1 & EP 1316627 A1 | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 December 2016 (22.12.16) | 10 January 2017 (10.01.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/082794

C (Continuation). DOCUMENTS CONSIDERED TO BE RELEVANT

| Category* | Citation of document, with indication, where appropriate, of the relevant passages | Relevant to claim No. |
|---|---|---|
| A | WO 2009/047867 A1 (Hitachi Tool Engineering Ltd.), 16 April 2009 (16.04.2009), claim 1; table 1, sample no.38 & US 2010/0215912 A1 claim 1; No.38 of table 1 & EP 2208560 A1 & KR 10-1200785 B1 & CN 101855035 A | 1-11 |
| A | JP 2004-338060 A (Mitsubishi Materials Kobe Tools Corp.), 02 December 2004 (02.12.2004), paragraph [0016]; table 4, kind type 15 (Family: none) | 1-11 |
| A | JP 2007-46103 A (Hitachi Tool Engineering Ltd.), 22 February 2007 (22.02.2007), paragraph [0008] (Family: none) | 1-11 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3877124 B
- JP 4846519 B
- JP 5487182 B
- JP 2009220260 A
- JP 2008533310 A